# EUROPEAN PATENT SPECIFICATION

(11) **EP 4 082 785 B1**
(45) Date of publication and mention of the grant of the patent: **08.07.2026**
(21) Application number: 20905695.1
(22) Date of filing: 11.12.2020
(51) Int. Cl.: B32B 27/20, C09K 5/14, C08K 3/28, C08K 3/22, C08K 3/38, C08K 5/1515, C08K 5/3492, C08K 5/353

(54) **COMPOSITION, HEAT CONDUCTIVE SHEET, AND DEVICE HAVING HEAT CONDUCTIVE SHEET**
ZUSAMMENSETZUNG, WÄRMELEITENDE PLATTE UND VORRICHTUNG MIT WÄRMELEITENDER FOLIE
COMPOSITION, FEUILLE THERMOCONDUCTRICE ET DISPOSITIF DOTÉ D'UNE FEUILLE THERMOCONDUCTRICE

(30) Priority: 26.12.2019 JP 2019236138
(43) Date of publication of application: 02.11.2022
(73) Proprietor: FUJIFILM Corporation, Tokyo 106-8620 (JP)
(72) Inventor: HAYASHI, Daisuke, Ashigarakami-gun, Kanagawa 258-8577 (JP); HITOMI, Seiichi, Ashigarakami-gun, Kanagawa 258-8577 (JP); NIORI, Teruki, Ashigarakami-gun, Kanagawa 258-8577 (JP); TAKAHASHI, Keita, Ashigarakami-gun, Kanagawa 258-8577 (JP)
(74) Representative: HGF
(86) International application number: PCT/JP2020/046333
(87) International publication number: WO 2021/131803

(56) References cited:
- EP-A1- 3 653 573
- WO-A1-2017/131007
- WO-A1-2019/013299
- WO-A1-2019/013323
- JP-A- 2013 029 792

## Description

### BACKGROUND OF THE INVENTION

### 1. Field of the Invention

The present invention relates to a composition, a thermally conductive sheet, and a device with a thermally conductive sheet.

### 2. Description of the Related Art

In recent years, a power semiconductor device used in various electrical machines such as a personal computer, a general household electric appliance, and an automobile has been rapidly miniaturized. With the miniaturization, it is difficult to control heat generated from the power semiconductor device having a high density.

In order to deal with such a problem, a thermally conductive sheet, which promotes heat dissipation from the power semiconductor device, is used.

PCT/JP2018/026388 discloses a thermally conductive material including a cured product of a disk-like compound containing one or more specific reactive functional groups and a crosslinking compound containing a group reacting with the reactive functional group. EP3653573A1 describes surface-modified inorganic nitrides, a composition, a thermally conductive material, and a device with a thermally conductive layer which contain the surface-modified inorganic nitride. JP2013029792A describes a cyclic olefin-based resin film, polarizing plate, and liquid crystal display unit.

### SUMMARY OF THE INVENTION

The present invention is as defined in the appended claims. The present inventors have examined physical properties of the thermally conductive material disclosed in PCT/JP2018/026388, and have found that there is room for further improvement in the peel strength of the sheet-shaped thermally conductive material (thermally conductive sheet).

Here, an object of the present invention is to provide a composition for forming a thermally conductive sheet having excellent peel strength.

Moreover, another object of the present invention is to provide a thermally conductive sheet formed of the composition and a device with a thermally conductive sheet.

As a result of a thorough examination, the present inventors have found that the objects can be achieved by the composition having a predetermined configuration, thereby completing the present invention.

That is, it was found that the objects can be achieved by the following configuration.
[1] A composition containing a disk-like compound in a content of 1% to 50% by mass, with respect to a total mass of the solid content of the composition, a high-molecular-weight compound in a content of 0.1% to 30% by mass, with respect to a total mass of the solid content of the composition, and which is at least one selected from the group consisting of a thermoplastic resin and rubber, and inorganic particles in a content of 30% by mass or greater, with respect to a total mass of the solid content of the composition, wherein the inorganic particles are selected from particles of inorganic oxides, inorganic nitrides, and inorganic oxynitrides, and wherein the disk-like compound is represented by one of Formulae (D1) to (D16) as defined herein.
[2] The composition as described in [1], in which the high-molecular-weight compound contains a thermoplastic resin having an aromatic ring in a main chain.
[3] The composition as described in [1] or [2], in which the high-molecular-weight compound includes at least one selected from the group consisting of polysulfone, polyethersulfone, polyetheretherketone, polyetherimide, modified polyphenylene ether, polycarbonate, amorphous polyarylate, liquid crystal polymer, polyimide, and polyphenylene sulfide.
[4] The composition as described in any one of [1] to [3], in which a ratio of a content of the high-molecular-weight compound to a content of the inorganic particles is 0.01 to 0.2 by mass ratio.
[5] The composition as described in any one of [1] to [4], in which the ratio of the content of the high-molecular-weight compound to the content of the inorganic particles is 0.02 to 0.12 by mass ratio.
[6] The composition as described in any one of [1] to [5], in which the ratio of the content of the high-molecular-weight compound to the content of the inorganic particles is 0.04 to 0.08 by mass ratio.
[7] The composition as described in any one of [1] to [6], in which the content of the high-molecular-weight compound is 1% to 15% by mass with respect to a total mass of a solid content contained in the composition.
[8] The composition as described in any one of [1] to [7], in which the content of the high-molecular-weight compound is 3% to 10% by mass with respect to the total mass of the solid content contained in the composition.
[9] The composition as described in any one of [1] to [8], in which the inorganic particles are particles of an inorganic oxide or an inorganic nitride.
[10] The composition as described in any one of [1] to [9], in which the inorganic particles are boron nitride particles.
[11] The composition as described in any one of [1] to [10], further including a curing accelerator.
[12] A thermally conductive sheet formed by curing the composition as described in any one of [1] to [11].
[13] The thermally conductive sheet as described in [12], in which a toughness parameter of the thermally conductive sheet measured by a test method 1 described later is 30 MPa·% or greater.
[14] The thermally conductive sheet as described in [12] or [13], in which an adhesive layer or a pressure sensitive adhesive layer is provided on one surface or both surfaces of the thermally conductive sheet.
[15] A device with a thermally conductive sheet including a device and the thermally conductive sheet as described in any one of [12] to [14] disposed on the device.

According to the present invention, it is possible to provide a composition capable of forming a thermally conductive sheet having excellent peel strength.

In addition, according to the present invention, it is possible to provide a thermally conductive sheet formed by the composition and a device with a thermally conductive sheet.

### DESCRIPTION OF THE PREFERRED EMBODIMENTS

Hereinafter, a composition, a thermally conductive sheet, and a device with a thermally conductive sheet according to an embodiment of the present invention will be described in detail.

In the present specification, in a case where two or more kinds of a certain component are present, the "content" of the component means a total content of the two or more kinds of components.

In the present specification, the description of "(meth)acryloyl group" means "either or both of an acryloyl group and a methacryloyl group".

In the present specification, the description of "(meth)acrylamide group" means "either or both of an acrylamide group and a methacrylamide group".

Furthermore, in the present specification, the kind of a substituent, the position of a substituent, and the number of substituents in a case where "a substituent may be contained" are not particularly limited. Examples of the number of substituents include 1 or 2 or more. Examples of the substituent include a monovalent nonmetallic atomic group excluding a hydrogen atom, and the substituent can be selected from the following substituent group Y.

Substituent group Y:
a halogen atom (-F, -Br, -Cl, -I), a hydroxyl group, an amino group, a carboxylic acid group and a conjugated base group thereof, a carboxylic acid anhydride group, a cyanate ester group, an unsaturated polymerizable group, an oxiranyl group, an oxetanyl group, an aziridinyl group, a thiol group, an isocyanate group, an thioisocyanate group, an aldehyde group, an alkoxy group, an aryloxy group, an alkylthio group, an arylthio group, an alkyldithio group, an aryldithio group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugated base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugated base group thereof, an N-alkylsulfonylsulfamoyl group (-SO₂NHSO₂(alkyl)) and a conjugated base group thereof, an N-arylsulfonylsulfamoyl group (-SO₂NHSO₂(aryl)) and a conjugated base group thereof, an N-alkylsulfonylcarbamoyl group (-CONHSO₂(alkyl)) and a conjugated base group thereof, an N-arylsulfonylcarbamoyl group (-CONHSO₂(aryl)) and a conjugated base group thereof, an alkoxysilyl group (-Si(Oalkyl)₃), an aryloxysilyl group (-Si(Oaryl)₃), a hydroxysilyl group (-Si(OH)3) and a conjugated base group thereof, a phosphono group (-PO₃H₂) and a conjugated base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugated base group thereof, a monoarylphosphono group (-PO₃H(aryl)) and a conjugated base group thereof, a phosphonooxy group (-OPO₃H₂) and a conjugated base group thereof, a dialkylphosphonooxy group (-OPO3(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and a conjugated base group thereof, a monoarylphosphonooxy group (-OPO₃H(aryl)) and a conjugated base group thereof, a cyano group, a nitro group, an aryl group, an alkenyl group, an alkynyl group, and an alkyl group.

Moreover, these substituents may form a ring by being bonded to each other, if possible, or by being bonded to a group substituted with the substituent.

Examples of the unsaturated polymerizable group include a (meth)acryloyl group, a (meth)acrylamide group, and a substituent represented by Q1 to Q7 below.

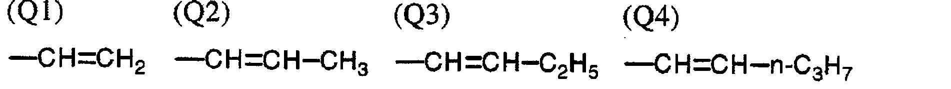

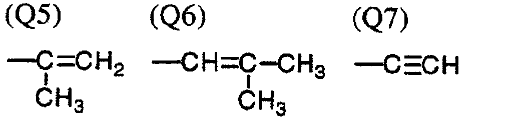

A bonding direction of a divalent group described in the present specification is not particularly limited unless otherwise specified. For example, in the compound represented by General Formula "L-M-N", in a case where M is -C(=O)-O-, a position bonded to an L side is set to *1 and a position bonded to an N side is set to *2, M may be *1-C(=O)-O-*2, or may be *1-O-C(=O)-*2.

### [Composition]

The composition of the embodiment of the present invention contains a disk-like compound, a high-molecular-weight compound (hereinafter, also referred to as "specific polymer") which is at least one selected from the group consisting of a thermoplastic resin and rubber, and inorganic particles.

Hereinafter, each component contained in the composition will be described in detail.

### [disk-like compound]

The composition of the present invention contains a disk-like compound. The disk-like compound is used as a raw material for forming a thermally conductive sheet.

In the present specification, the disk-like compound means a compound having a disk-like structure at least partially. The disk-like structure has at least a non-aromatic ring or an aromatic ring. In particular, in a case where the disk-like structure has an aromatic ring, the disk-like compound can form a columnar structure by forming a stacking structure based on an intermolecular π-π interaction.

Examples of the disk-like structure include the triphenylene structure described in Angew. Chem. Int. Ed. 2012, 51, 7990 to 7993, or JP1995-306317A (JP-H7-306317A), and the trisubstituted benzene structures described in JP2007-002220A and JP2010-244038A.

The disk-like compound may be a liquid crystal compound exhibiting liquid crystallinity or a non-liquid crystal compound not exhibiting liquid crystallinity, but the liquid crystal compound is preferable from a viewpoint of more excellent thermally conductive properties of the thermally conductive sheet. That is, as the disk-like compound, a disk-like liquid crystal compound is preferable.

Specific examples of the disk-like compound include compounds described in C. Destrade et al., Mol. Crysr. Liq. Cryst., vol. 71, page 111 (1981); edited by The Chemical Society of Japan, Quarterly Review of Chemistry, No. 22, Chemistry of liquid crystal, Chapter 5, Chapter 10, Section 2 (1994); B. Kohne et al., Angew. Chem. Int. Ed., 23, 82 (1984); J. Zhang et al., J. Am. Chem. Soc., vol. 116, 2655 (1994), and JP4592225B.

The disk-like compound preferably has at least one of any of the substituents exemplified in the aforementioned substituent group Y.

More specifically, examples of the substituent include a hydroxyl group (-OH), a carboxylic acid group (-COOH), an carboxylic acid anhydride group, an amino group (-NH₂), a cyanate ester group (-O-C≡N), a halogen atom, an isocyanate group, a cyano group, the unsaturated polymerizable group, an oxiranyl group, an oxetanyl group, an aziridinyl group, a thiol group, a thioisocyanate group, an aldehyde group, and a sulfo group.

Among them, a substituent having three or more specific functional groups selected from the group consisting of a (meth)acrylic group, a (meth)acrylamide group, an oxiranyl group, an oxetanyl group, a hydroxyl group, an amino group, a thiol group, an isocyanate group, a carboxyl group, and an carboxylic acid anhydride group is preferable from a viewpoint of more excellent thermally conductive properties of the thermally conductive sheet. The thermally conductive sheet formed by using the disk-like compound having three or more specific functional groups tends to have a high glass transition temperature and high heat resistance.

An upper limit of the number of the specific functional groups is not particularly limited, but is preferably 8 or less, and more preferably 6 or less.

As the disk-like compound, a compound selected from the group consisting of the compounds represented by Formulae (D1) to (D16) is preferable, and a compound represented by Formula (D4) or a compound represented by Formula (D16) is more preferable from a viewpoint of more excellent thermally conductive properties of the thermally conductive sheet.

In the following formulae, "-LQ" represents "-L-Q", and represents "QL-" or "Q-L-".

Hereinafter, Formulae (D1) to (D15) will be described first.

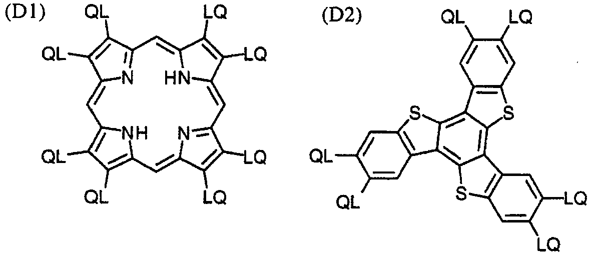

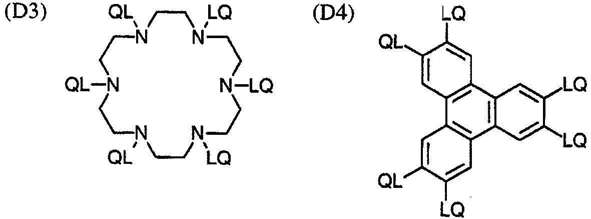

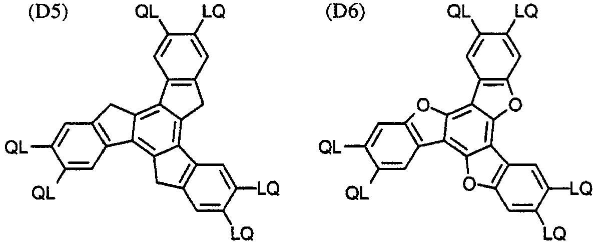

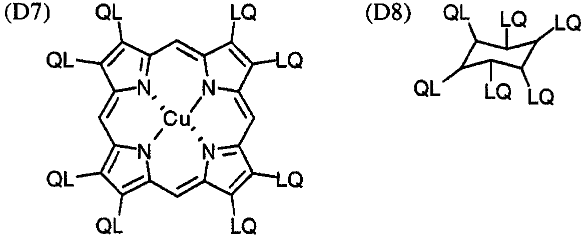

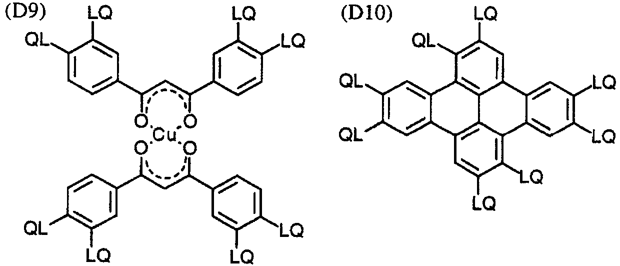

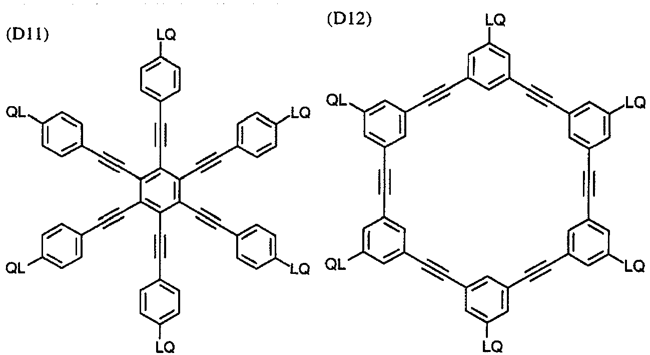

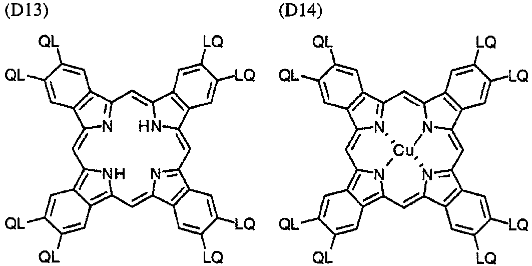

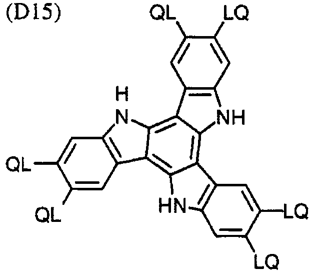

In Formulae (D1) to (D15), L represents a divalent linking group. The plurality of L may be the same or different.

From a viewpoint of more excellent thermally conductive properties of the thermally conductive sheet, L is preferably a group selected from the group consisting of an alkylene group, an alkenylene group, an arylene group, -C(=O)-, -NH-, -O-, -S-, and a combination thereof, and is more preferably a group obtained by combining two or more groups selected from the group consisting of an alkylene group, an alkenylene group, an arylene group, -C(=O)-, -NH-, -O-, and -S-. Among them, a divalent linking group containing -C(=O)-O- is even more preferable.

The number of carbon atoms in the alkylene group is preferably 1 to 12. The number of carbon atoms in the alkenylene group is preferably 2 to 12. The number of carbon atoms in the arylene group is preferably 10 or less. The alkylene group, the alkenylene group, and the arylene group may further have a substituent. The substituent is not particularly limited, but examples thereof include an alkyl group (preferably 1 to 6 carbon atoms), a halogen atom, a cyano group, an alkoxy group (preferably 1 to 6 carbon atoms), and an acyloxy group (preferably 1 to 6 carbon atoms).

An example of L is shown below. In the following example, a bonding site on a left side is bonded to a central nucleus of the compound represented by any of Formulae (D1) to (D15) (hereinafter, also simply referred to as "central ring"), and a bonding site on a right side is bonded to Q.

AL means an alkylene group or an alkenylene group, and AR means an arylene group.
L101: -AL-C(=O)-O-AL-
L102: -AL-C(=O)-O-AL-O-
L103: -AL-C(=O)-O-AL-O-AL-
L104: -C(=O)-AR-O-AL-
L105: -C(=O)-AR-O-AL-O-
L106: -NH-AL-O-
L107: -AL-C(=O)-O-AL-AR-
L108: -AL-C(=O)-O-AR-
L109: -O-AL-NH-AR-
L110: -O-AL-O-C(=O)-NH-AL-
L111: -O-AL-S-AL-
L112: -O-C(=O)-AL-AR-O-AL-
L113: -O-C(=O)-AL-AR-O-AL-O-
L114: -O-C(=O)-AR-O-AL-C(=O)-
L115: -O-C(=O)-AR-O-AL-
L116: -O-C(=O)-AR-O-AL-O-
L117: -O-C(=O)-AR-O-AL-O-AL-
L118: -O-C(=O)-AR-O-AL-O-AL-O-
L119: -O-C(=O)-AR-O-AL-O-AL-O-AL-
L120: -O-C(=O)-AR-O-AL-O-AL-O-AL-O-
L121: -S-AL-
L122: -S-AL-O-
L123: -S-AL-S-AL-
L124: -S-AR-AL-
L125: -O-C(=O)-AL-
L126: -O-C(=O)-AL-O-
L127: -O-C(=O)-AR-O-AL-
L128: -O-C(=O)-AR-O-AL-O-C(=O)-AL-S-AR-
L129: -O-C(=O)-AL-S-AR-
L130: -O-C(=O)-AR-O-AL-O-C(=O)-AL-S-AL-
L131: -O-C(=O)-AL-S-AR-
L132: -O-AL-S-AR-
L133: -AL-C(=O)-O-AL-O-C(=O)-AL-S-AR-
L134: -AL-C(=O)-O-AL-O-C(=O)-AL-S-AL-
L135: -AL-C(=O)-O-AL-O-AR-
L136: -O-AL-O-C(=O)-AR-
L137: -O-C(=O)-AL-O-AR-
L138: -O-C(=O)-AR-O-AL-O-AR-

In Formulae (D1) to (D15), Q represents a hydrogen atom or a substituent. The plurality of Q's may be the same or different.

Examples of the substituent include groups exemplified in the aforementioned substituent group Y. More specifically, examples of the substituent include a hydroxyl group (-OH), a carboxylic acid group (-COOH), an carboxylic acid anhydride group, an amino group (-NH₂), a cyanate ester group (-O-C=N), a halogen atom, an isocyanate group, a cyano group, the unsaturated polymerizable group, an oxiranyl group, an oxetanyl group, an aziridinyl group, a thiol group, a thioisocyanate group, an aldehyde group, and a sulfo group.

Among them, three or more Qs in Formulae (D1) to (D15) each independently preferably represent a specific functional group selected from the group consisting of a (meth)acrylic group, a (meth)acrylamide group, and an oxiranyl group, an oxetanyl group, a hydroxyl group, an amino group, a thiol group, an isocyanate group, a carboxyl group, and an carboxylic acid anhydride group, from a viewpoint of more excellent thermally conductive properties of the thermally conductive sheet. The thermally conductive sheet formed by using a disk-like compound containing three or more specific functional groups tends to have a high glass transition temperature and high heat resistance. This is because, as compared with a rod-like compound, the disk-like compound is less likely to be affected by the characteristics of the mesogenic moiety even if the disk-like compound contains three or more of the specific functional groups.

In Formulae (D1) to (D15), it is preferable that 8 or less Qs represent the specific functional group, and it is more preferable that 6 or less Qs represent the specific functional group.

In a case where Q represents a hydroxyl group, it is preferable that L represents a single bond and Q represents a hydroxyl group directly bonded to the central ring.

In addition, the carboxylic acid anhydride group represents a monovalent substituent obtained by removing any hydrogen atom from an acid anhydride such as maleic acid anhydride, phthalic acid anhydride, pyromellitic acid anhydride, and trimellitic acid anhydride.

Q preferably has no fluorine atom. In other words, Q preferably represents a substituent having no fluorine atom or a hydrogen atom. Among them, the compounds represented by Formulae (D1) to (D15) more preferably have no fluorine atom. That is, it is more preferable that L and Q do not have a fluorine atom.

It is preferable that Q does not have an alkyl group having 10 or more carbon atoms. In other words, Q preferably represents a substituent having no alkyl group having 10 or more carbon atoms or a hydrogen atom. Among them, it is more preferable that the compounds represented by Formulae (D1) to (D15) do not have an alkyl group having 10 or more carbon atoms. That is, it is more preferable that L and Q do not have an alkyl group having 10 or more carbon atoms.

Among the compounds represented by Formulae (D1) to (D15), the compound represented by Formula (D4) is preferable from a viewpoint of more excellent thermally conductive properties of the thermally conductive sheet.

As the compound represented by Formula (D4), the compound represented by Formula (XI) is preferable from a viewpoint of more excellent thermally conductive properties of the thermally conductive sheet.

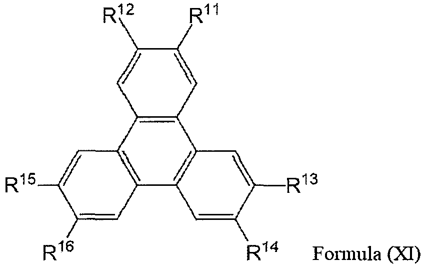

In Formula (XI), R¹¹, R¹², R¹³, R¹⁴, R¹⁵, and R¹⁶ each independently represent *-X¹¹-L¹¹-P¹¹ or *-X¹²-L¹²-Y¹². * represents a bonding position with a triphenylene ring.

Among R¹¹, R¹², R¹³, R¹⁴, R¹⁵, and R¹⁶, two or more are preferably *-X¹¹-L¹¹-P¹¹, and three or more are more preferably *-X¹¹-L¹¹-P¹¹.

Among them, from a viewpoint of more excellent thermally conductive properties of the thermally conductive sheet, one or more of R¹¹ and R¹², one or more of R¹³ and R¹⁴, and one or more of R¹⁵ and R¹⁶ are preferably *-X¹¹-L¹¹-P¹¹, and all of R¹¹, R¹², R¹³, R¹⁴, R¹⁵, and R¹⁶ are more preferably *-X¹¹-L¹¹-P¹¹. In addition, it is more preferable that R¹¹, R¹², R¹³, R¹⁴, R¹⁵, and R¹⁶ are all the same.

X¹¹ represents a single bond, -O-, -C(=O)-, -NH-, -OC(=O)-, -OC(=O)O-, -OC(=O) NH-, -OC(=O)S-, -C(=O) O-, -C(=O)NH-, -C(= O)S-, -NHC(=O)NH-, -NHC(=O)S-, -S-, -SC(=O)-, -SC(=O)O-, -SC(=O)NH-, or -SC(=O)S-.

As X¹¹, -O-, -OC(=O)-, -OC(=O)O-, -OC(=O)NH-, -C(=O)O-, or -C(=O)NH- is preferable, -O-, -OC(=O)-, -C(=O)O-, -OC(=O)NH-, or -C(=O)NH- is more preferable, and -O-, -OC(=O)-, or -C(=O)O- is even more preferable.

L¹¹ represents a single bond or a divalent linking group.

Examples of the divalent linking group include -O-, -C(=O)-, -C(=O)O-, -S-, -NH-, an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), and a group obtained by combining thereof.

Examples of the alkylene group include a methylene group, an ethylene group, a propylene group, a butylene group, a pentylene group, a hexylene group, and a heptylene group.

Examples of the arylene group include a 1,4-phenylene group, a 1,3-phenylene group, a 1,4-naphthylene group, a 1,5-naphthylene group, and an anthrasenylene group, and a 1,4-phenylene group is preferable.

The alkylene group and the arylene group may each have a substituent. The number of substituents of the alkylene group or the arylene group is preferably 1 to 3, and more preferably 1. The substitution position of the substituent is not particularly limited. As the substituent, a halogen atom or an alkyl group having 1 to 3 carbon atoms is preferable, and a methyl group is more preferable.

It is also preferable that the alkylene group and the arylene group are unsubstituted. Among them, it is more preferable that the alkylene group is unsubstituted.

Examples of -X¹¹-L¹¹- include L101 to L138, which are examples of the aforementioned L.

P¹¹ represents a hydroxyl group, a carboxylic acid group, an carboxylic acid anhydride group, an amino group, a thiol group, a cyanate ester group, or the unsaturated polymerizable group.

In a case where P¹¹ is a hydroxyl group, it is preferable that L¹¹ contains an arylene group, and this arylene group is bonded to P¹¹.

X¹² is synonymous with X¹¹ and has the same preferred aspects.

L¹² is synonymous with L¹¹, and the preferred aspect is also the same.

Examples of -X¹² -L¹²- include L101 to L138, which are examples of the aforementioned L.

Y¹² represents a hydrogen atom, a linear, branched, or cyclic alkyl group having 1 to 20 carbon atoms, a group in which one or two or more methylene groups in a linear, branched, or cyclic alkyl group having 1 to 20 carbon atoms are substituted with -O-, -S-, -NH-, -N(CH₃)-, -C(=O)-, or -OC(=O)-.

In a case where Y¹² is a linear, branched, or cyclic alkyl group having 1 to 20 carbon atoms or a group in which one or two or more methylene groups in the linear, branched, or cyclic alkyl group having 1 to 20 carbon atoms are substituted with -O-, -S-, -NH-, -N(CH₃)-, -C(=O)-, or -OC(=O)-, one or more of the hydrogen atoms contained in Y¹² may be substituted with halogen atoms.

Y¹² is preferably a hydrogen atom, a linear, branched, or cyclic alkyl group having 1 to 20 carbon atoms, or an alkylene oxide group having 1 to 20 carbon atoms, and is more preferably a linear or branched alkyl group having 1 to 12 carbon atoms, an ethylene oxide group, or a propylene oxide group.

Specific examples of the compound represented by Formula (XI) include compounds described in paragraphs 0028 to 0036 of JP1995-281028A (JP-H7-281028A), JP1995-306317A (JP-H7-306317A), paragraphs 0016 to 0018 of JP2005-156822A, paragraphs 0067 to 0072 of JP2006-301614A, and pages 330 to 333 of the LCD Handbook (published by Maruzen Co., Ltd., 2000).

The compound represented by Formula (XI) can be synthesized in accordance with the methods described in JP1995-306317A (JP-H7-306317A), JP1995-281028A (JP-H7-281028A), JP2005-156822A, and JP2006-301614A.

Next, Formula (D16) will be described.

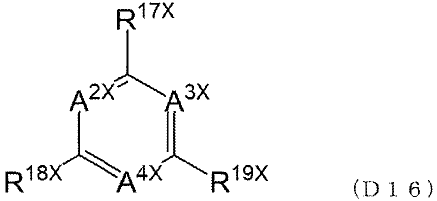

In Formula (D16), A^{2X}, A^{3X}, and A^{4X} each independently represent -CH= or -N=. Among them, it is preferable that A^{2X}, A^{3X}, and A^{4X} all represent -CH=, or A^{2X}, A^{3X}, and A^{4X} all represent -N=, and it is more preferable that A^{2X}, A^{3X}, and A^{4X} all represent -CH=.

R^{17X}, R^{18X}, and R^{19X} each independently represent *-(X^{211X}-Z^{21X})_{n21X}-L^{21X}-Q. * represents the bonding position with the central ring (corresponding to the 6-membered aromatic ring represented by Formula (D16)).

X^{211X} represents a single bond, -O-, -C(=O)-, -NH-, -OC (=O)-, -OC(=O)O-, -OC(=O)NH-, -OC(=O)S-, -C(=O)O-, -C(=O)NH-, -C (=O)S-, -NHC(=O)NH-, -NHC(=O)S -, -S-, -SC(=O)-, -SC(=O)O-, -SC(=O)NH-, or -SC(=O)S-.

Z^{21X} represents a 5-membered or 6-membered aromatic ring group or a 5-membered or 6-membered non-aromatic ring group.

L^{21X} represents a single bond or a divalent linking group.

Q has the same as Q in Formulae (D1) to (D15), and the preferred aspect is also the same.

n21X represents an integer of 0 to 3. In a case where n21X is 2 or greater, a plurality of (X^{211X}-Z^{21X}) may be the same or different. As n21X, an integer of 1 to 3 is preferable. Among them, 1 or 2 is more preferable, and 1 is even more preferable from a viewpoint of more excellent thermally conductive properties of the thermally conductive sheet.

Q preferably has no fluorine atom. In other words, Q preferably represents a substituent having no fluorine atom or a hydrogen atom. Among them, it is more preferable that the compound represented by Formula (D16) does not have a fluorine atom.

It is preferable that Q does not have an alkyl group having 10 or more carbon atoms. In other words, Q preferably represents a substituent having no alkyl group having 10 or more carbon atoms or a hydrogen atom. Among them, it is more preferable that the compound represented by Formula (D16) does not have an alkyl group having 10 or more carbon atoms.

As the compound represented by Formula (D16), a compound represented by Formula (XII) is preferable.

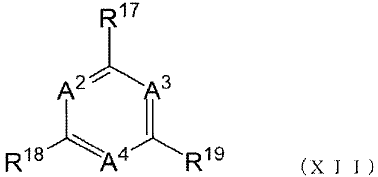

In Formula (XII), A², A³, and A⁴ each independently represent -CH= or -N=. Among them, it is preferable that A², A³, and A⁴ all represent -CH=, or A², A³, and A⁴ all represent -N=. In other words, the central ring of the disk-like compound (corresponding to the 6-membered aromatic ring represented by Formula (D16)) is preferably a benzene ring or a triazine ring.

R¹⁷, R¹⁸, and R¹⁹ each independently represent *-(X²¹¹-Z²¹)ₙ₂₁-L²¹-P²¹ or *-(X²²¹-Z²²)ₙ₂₂-Y²². * represents a bonding position with the central ring.

Two or more of R¹⁷, R¹⁸, and R¹⁹ are *-(X²¹¹-Z²¹)ₙ₂₁-L²¹-P²¹. It is preferable that all of R¹⁷, R¹⁸, and R¹⁹ are *-(X²¹¹-Z²¹)ₙ₂₁-L²¹-P²¹ from a viewpoint of more excellent thermally conductive properties of the thermally conductive sheet. In addition, it is more preferable that R¹⁷, R¹⁸, and R¹⁹ are all the same.

X²¹¹ and X²²¹ each independently represent a single bond, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)NH-, -NHC(=O)S-, -S-, -SC(=O)-, -SC(=O)O-, -SC(=O)NH-, or -SC(=O)S-.

As X²¹¹ and X²²¹, a single bond, -O-, -C(=O)O-, or -OC(=O)- is preferable.

Z²¹ and Z²² each independently represent a 5-membered or 6-membered aromatic ring group, or a 5-membered or 6-membered non-aromatic ring group, and examples thereof include a 1,4-phenylene group, a 1,3-phenylene group, and an aromatic heterocyclic group.

The aromatic ring group and the non-aromatic ring group may have a substituent. The number of substituents is preferably 1 or 2, and more preferably 1. The substitution position of the substituent is not particularly limited. As the substituent, a halogen atom or a methyl group is preferable. It is also preferable that the aromatic ring group and the non-aromatic ring group are unsubstituted.

Examples of the aromatic heterocyclic group include the following aromatic heterocyclic groups.

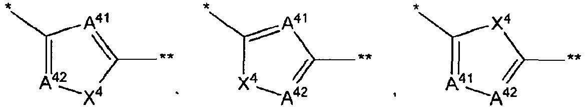

In the formula, * represents a site of the one that is bonded to X²¹¹ or X²²¹. ** represents a site of the one that is bonded to L²¹ or Y²², A⁴¹ and A⁴² each independently represent a methine group or a nitrogen atom. X⁴ represents an oxygen atom, a sulfur atom, a methylene group, or an imino group.

Preferably at least one of A⁴¹ or A⁴² is a nitrogen atom, and more preferably both of A⁴¹ and A⁴² are nitrogen atoms. In addition, X⁴ is preferably an oxygen atom.

In a case where n21 and n22 to be described later are two or greater, a plurality of (X²¹¹-Z²¹) and (X²²¹-Z²²) may be the same or different, respectively.

L²¹ represents a single bond or a divalent linking group, and is synonymous with L¹¹ in the aforementioned Formula (XI). L²¹ is preferably -O-, -OC(=O)-, -S-, -NH-, and an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group obtained by combining these.

In a case where n22 to be described later is 1 or greater, examples of -L²¹- similarly include L101 to L138, which are examples of L in the aforementioned Formulae (D1) to (D15).

P²¹ represents a hydroxyl group, a carboxylic acid group, an carboxylic acid anhydride group, an amino group, a thiol group, a cyanate ester group, or the unsaturated polymerizable group.

Y²² represents a group in which a hydrogen atom, a linear, branched, or cyclic alkyl group having 1 to 20 carbon atoms, or one or two or more methylene groups in a linear, branched, or cyclic alkyl group having 1 to 20 carbon atoms is substituted with -O-, -S-, -NH-, -N(CH₃)-, -C(=O)-, or -OC(=O)-. The preferred aspect of Y²² is the same as the preferred aspect of Y¹² in Formula (XI).

n21 and n22 each independently represent an integer of 0 to 3, and an integer of 1 to 3 is preferable. Among them, 1 or 2 is more preferable, and 1 is even more preferable from a viewpoint of more excellent thermally conductive properties of the thermally conductive sheet.

Preferable examples of the compound represented by Formula (XII) include the following compounds.

In the following structural formula, R represents -L²¹-P²¹.

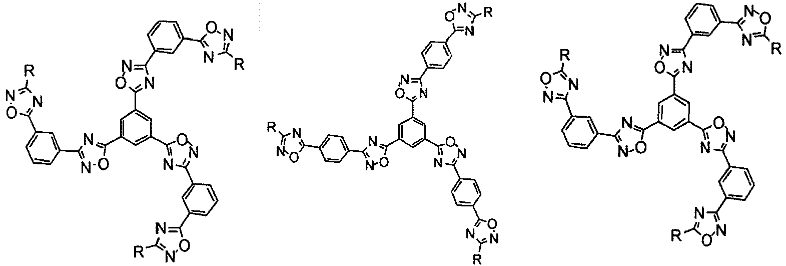

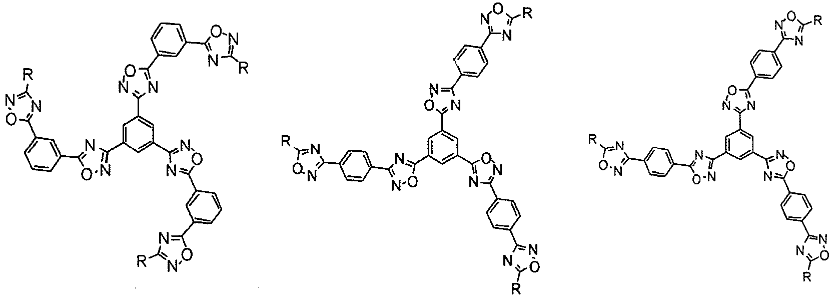

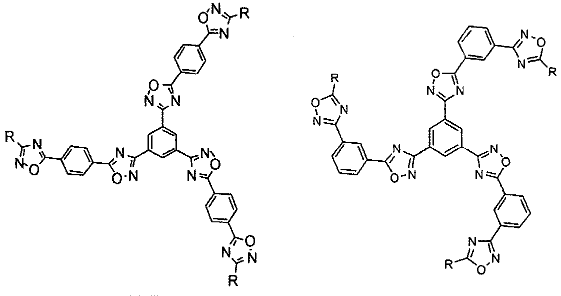

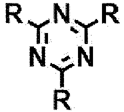

For details and specific examples of the compound represented by Formula (XII), the description in paragraphs 0013 to 0077 of JP2010-244038A can be referred to.

The compound represented by Formula (XII) can be synthesized in accordance with the methods described in JP2010-244038A, JP2006-076992A, and JP2007-002220A.

Since the density (crosslinking density) of the thermally conductive sheet formed by using the composition becomes high and the thermally conductive properties of the thermally conductive sheet is further improved, in the compounds represented by Formulae (D1) to (D16), it is preferable that the length of the divalent linking group connecting the central ring and the specific functional group represented by Q is short. More specifically, in the divalent linking group (L or L^{21X}) connecting the central ring and the specific functional group, the number of atoms in the bond that connects the atom bonded to the central ring and the atom bonded to the specific functional group at the shortest distance (hereinafter, also referred to as "the number of atoms between both ends of the divalent linking group") is preferably 11 or less, and preferably 7 or less.

In the calculation of the number of atoms between both ends of the divalent linking group, both the atom bonded to the ring as a starting point and the atom bonded to the specific functional group as an ending point are counted.

A lower limit of the number of atoms between both ends of the divalent linking group is not particularly limited and may be 0. That is, in the compounds represented by the above formulae (D1) to (D16), the central ring and the specific functional group represented by Q may be directly bonded.

As will be described later, in a case where the thermally conductive sheet formed by using the composition containing the disk-like compound contains a cured product obtained by curing the composition containing the disk-like compound, the composition may contain a disk-like compound as a main agent, or as a curing agent. In addition, the composition may contain a disk-like compound as both a main agent and a curing agent. The composition preferably contains at least a disk-like compound as a main agent.

In the present specification, the "main agent" means a compound having a functional group selected from the group consisting of an unsaturated polymerizable group ((meth)acrylic group, (meth)acrylamide group, and the like), an oxiranyl group, an oxetanyl group, and an aziridinyl group.

In addition, in the present specification, the "curing agent" means a compound having a functional group selected from the group consisting of a hydroxyl group, an amino group, a thiol group, an isocyanate group, a thioisocyanate group, an aldehyde group, a carboxyl group, an carboxylic acid anhydride group, and a sulfo group.

In a case where the composition is cured to form a thermally conductive sheet, the composition may or may not contain a curing agent as a disk-like compound or a curable compound described later.

When the disk-like compound represented by Formulae (D1) to (D16) is the main agent, one or more Qs are preferably reactive groups selected from the group consisting of a (meth)acrylic group, a (meth)acrylamide group, an oxiranyl group, and an oxetanyl group. Among them, from a viewpoint of more excellent thermally conductive properties of the thermally conductive sheet, it is more preferable that two or more Qs are the reactive groups, and it is even more preferable that three or more Qs are the reactive groups. An upper limit of the number of Qs, which are the reactive groups, is not particularly limited, but is preferably 8 or less, and more preferably 6 or less.

As the reactive group, an oxiranyl group or an oxetanyl group is more preferable, and an oxiranyl group is even more preferable.

When the disk-like compound represented by Formulae (D1) to (D16) is a curing agent, one or more Qs are active hydrogen-containing functional groups selected from the group consisting of a hydroxyl group, an amino group, a thiol group, an isocyanate group, a carboxyl group, and an carboxylic acid anhydride group. Among them, from a viewpoint of more excellent thermally conductive properties of the thermally conductive sheet, two or more Qs are more preferably the active hydrogen-containing functional groups, and three or more Qs are even more preferably the active hydrogen-containing functional groups. An upper limit of the number of Qs, which are the active hydrogen-containing functional groups, is not particularly limited, but is preferably 8 or less, and more preferably 6 or less. As the active hydrogen-containing functional group, a hydroxyl group, an amino group, a thiol group, or an carboxylic acid anhydride group is more preferable, and a hydroxyl group or an amino group is even more preferable.

One kind of the disk-like compounds may be used singly, or two or more kinds thereof may be used in combination.

A content of the disk-like compound in the composition is preferably 1% to 50% by mass, more preferably 3% to 40% by mass, and even more preferably 5% to 30% by mass, with respect to a total mass of the solid content of the composition.

The solid content means a component of the composition that forms a thermally conductive sheet, and the solvent is removed. The solid content is calculated as a solid content even if the property is liquid.

### [Specific polymer]

The composition according to the embodiment of the present invention contains at least one high-molecular-weight compound (specific polymer) selected from the group consisting of thermoplastic resins and rubbers. As the composition contains the specific polymer together with the disk-like compound and the inorganic particles, a thermally conductive sheet having excellent peel strength can be formed.

The thermoplastic resin is not particularly limited as long as it is a resin that is plasticized by performing heating to a glass transition temperature (Tg) or a melting point or higher. In the present specification, the thermoplastic resin includes a thermoplastic elastomer.

In addition, the rubber may be natural rubber or synthetic rubber, but synthetic rubber is preferable.

Among the thermoplastic resins, examples of the thermoplastic resin having a cyclic structure such as an aromatic ring in the main chain include polyamide (PA), polycarbonate (PC), modified polyphenylene ether (m-PPE), polyethylene terephthalate (PET), polybutylene terephthalate (PBT), cyclic polyolefin (COP), polyphenylenesulfide (PPS), polytetrafluoroethylene (PTFE), polysulfone (PSF), polyethersulfone (PES), amorphous polyarylate (PAR), polyetheretherketone (PEEK), thermoplastic polyimide (PI), polyetherimide (PEI), and polyamideimide (PAI).

Among the thermoplastic resins, examples of the thermoplastic resin having no cyclic structure in the main chain include polyethylene (PE), polypropylene (PP), polyvinyl chloride (PVC), polyvinylidene chloride, polystyrene (PS), polyvinyl acetate (PVAC), polytetrafluoroethylene (PTFE), ABS resin (acrylonitrile butadiene resin), AS resin (acrylic nitrile styrene resin), acrylic resin (PMMA), and polyacetal (POM).

Examples of the thermoplastic elastomer include polyolefin-based thermoplastic elastomers, polyester-based thermoplastic elastomers, polyurethane-based thermoplastic elastomers, PVC (polyvinyl chloride), and nitrile rubber.

Examples of the rubber include styrene-butadiene copolymer, polybutadiene, polyisoprene, butadiene-isoprene copolymer, butadiene-styrene-isoprene copolymer, acrylonitrile-butadiene copolymer, chloroprene rubber, butyl rubber, halogenated butyl rubber, urethane rubber, silicone rubber, fluororubber, chlorinated polyethylene rubber, and acrylic rubber.

As the specific polymer, a thermoplastic resin having a cyclic structure in the main chain is preferable, and a thermoplastic resin having an aromatic ring in the main chain is more preferable, from a viewpoint of excellent thermally conductive properties of the thermally conductive sheet. Although the detailed reason why the thermally conductive properties are improved by using these resins is unknown, it is presumed that the thermally conductive properties are improved due to the π-π interaction between molecules of the cyclic structure (preferably aromatic ring) of these resins and the disk-like structure of aromatic ring and the like of the disk-like compound.

Among them, polycarbonate (PC), modified polyphenylene ether (m-PPE), polysulfone (PSF), polyethersulfone (PES), polyetheretherketone (PEEK), polyetherimide (PI), amorphous polyarylate, liquid crystal polymer, polyimide, or polyphenylene sulfide is even more preferable, and polysulfone, polyethersulfone, or polyetherimide is particularly preferable.

A weight average molecular weight of the specific polymer is not particularly limited, but is preferably 10,000 to 300,000, and more preferably 20,000 to 100,000.

One kind of the specific polymers may be used singly, or two or more kinds thereof may be used in combination.

A content of the specific polymer is preferably 0.1% to 30% by mass, more preferably 1% to 15% by mass, and even more preferably 3% to 10% by mass, with respect to the total mass of the solid content of the composition.

### [Inorganic particles]

The composition according to the embodiment of the present invention contains inorganic particles. As the composition contains inorganic particles, a thermally conductive sheet having excellent thermally conductive properties can be formed.

As the inorganic particles, any inorganic particles, which are used in an inorganic filler of a thermally conductive material in the related art, may be used. Examples of the inorganic particles include inorganic oxides, inorganic nitrides, and inorganic oxynitrides, and particles of inorganic oxides or inorganic nitrides are preferable.

A shape of the inorganic particles is not particularly limited, and may be a granule shape, may be a film shape, or may be a plate shape. Examples of the shape of the particles include a rice grain shape, a spherical shape, a cubical shape, a spindle shape, a scale shape, an aggregation shape, and an amorphous shape.

Examples of the inorganic oxide include zirconium oxide (ZrO₂), titanium oxide (TiO₂), silicon oxide (SiO₂), aluminum oxide (Al₂O₃), iron oxide (Fe₂O₃, FeO, or Fe₃O₄), copper oxide (CuO or Cu₂O), zinc oxide (ZnO), yttrium oxide (Y₂O₃), niobium oxide (Nb₂O₅), molybdenum oxide (MoO₃), indium oxide (In₂O₃ or In₂O), tin oxide (SnO₂), tantalum oxide (Ta₂O₅), tungsten oxide (WO₃ or W₂O₅), lead oxide (PbO or PbO₂), bismuth oxide (Bi₂O₃), cerium oxide (CeO₂ or Ce₂O₃), antimony oxide (Sb₂O₃ or Sb₂O₅), germanium oxide (GeO₂ or GeO), lanthanum oxide (La₂O₃), and ruthenium oxide (RuO₂).

Only one kind of inorganic oxides may be used, or two or more kinds thereof may be used.

The inorganic oxide is preferably titanium oxide, aluminum oxide, or zinc oxide.

The inorganic oxide may be an oxide which is produced by oxidizing a metal prepared as a nonoxide in an environment.

Examples of the inorganic nitride include boron nitride (BN), carbon nitride (C₃N₄), silicon nitride (Si₃N₄), gallium nitride (GaN), indium nitride (InN), aluminum nitride (AlN), chromium nitride (Cr₂N), copper nitride (Cu₃N), iron nitride (Fe₄N), iron nitride (Fe₃N), lanthanum nitride (LaN), lithium nitride (Li₃N), magnesium nitride (Mg₃N₂), molybdenum nitride (Mo₂N), niobium nitride (NbN), tantalum nitride (TaN), titanium nitride (TiN), tungsten nitride (W₂N), tungsten nitride (WN₂), yttrium nitride (YN), and zirconium nitride (ZrN).

Only one kind of inorganic nitrides may be used, or two or more kinds thereof may be used.

The inorganic nitride preferably contains an aluminum atom, a boron atom, or a silicon atom, more preferably contains aluminum nitride, boron nitride, or silicon nitride, even more preferably contains aluminum nitride or boron nitride, and particularly preferably contains boron nitride.

Among them, it is preferable that the inorganic particles contain an inorganic nitride, from a viewpoint of more excellent thermally conductive properties of the thermally conductive sheet.

A content of the inorganic nitride in the composition is preferably 40% by mass or greater, more preferably 60% by mass or greater, and even more preferably 80% by mass, with respect to the total mass of the inorganic particles, from a viewpoint of more excellent thermally conductive properties of the thermally conductive sheet.

A size of the inorganic particles is not particularly limited, but from a viewpoint of more excellent dispersibility of the inorganic particles, an average particle diameter of the inorganic particles is preferably 500 µm or less, more preferably 300 µm or less, and even more preferably 200 µm or less. The lower limit thereof is not particularly limited, but is preferably 10 nm or greater and more preferably 100 nm or greater, from the viewpoint of handleability.

The average particle diameter of the inorganic particles is obtained by randomly selecting 100 pieces of inorganic particles using an electron microscope, measuring particle diameters (long diameter) of the respective inorganic particles, and determining the arithmetic mean thereof. In a case of using a commercially available product of the inorganic particles, the catalog value may be used.

One kind of the inorganic particles may be used singly, or two or more kinds thereof may be used in combination. Among them, it is preferable to use two or more kinds of inorganic particles having different average particle diameters, and it is more preferable to use three or more kinds of inorganic particles having different average particle diameters.

The content of the inorganic particles in the composition is preferably 30% by mass or greater, and more preferably 40% by mass or greater, and from a viewpoint of more excellent thermally conductive properties of the thermally conductive sheet, even more preferably 55% by mass or greater, with respect to the total mass of the solid content of the composition. The upper limit is not particularly limited, but is preferably 95% by mass or less, and more preferably 90% by mass or less, with respect to the total mass of the solid content of the composition.

The content of the inorganic particles in the thermally conductive sheet is preferably 1% to 95% by mass, more preferably 5% to 95% by mass, even more preferably 30% to 90% by mass, and particularly preferably 40% to 90% by mass with respect to the total mass of the thermally conductive sheet.

In the composition, a ratio of the content of the specific polymer to the content of the inorganic particles (content of the specific polymer/content of the inorganic particles) is, by mass ratio, preferably 0.01 to 0.2, more preferably 0.02 to 0.12, and even more preferably 0.04 to 0.08 from a viewpoint of well balanced peel strength and thermally conductive properties of the thermally conductive sheet.

### [Optional component]

The composition may contain optional components other than the disk-like compound, specific polymer, and inorganic particles. Optional components include, for example, a solvent, other curing agents and main agents not corresponding to disk-like compounds (hereinafter, also referred to as "curable compounds" in the present specification), a curing accelerator, a dispersant, a surface modifier of inorganic particles, and a polymerization initiator.

The curable compound, the curing accelerator, and the polymerization initiator are components that may be contained in the composition as optional components in a case where the composition is cured to form a thermally conductive sheet.

In addition, the thermally conductive sheet may contain an uncured disk-like compound.

Hereinafter, optional components that may be contained in the composition will be described in detail.

### <Solvent>

The composition may further contain a solvent.

A kind of the solvent is not particularly limited, and an organic solvent is preferable. Examples of the organic solvent include ethyl acetate, methyl ethyl ketone (MEK), dichloromethane, tetrahydrofuran (THF), hexane, cyclopentanone, and cyclohexanone.

One kind of the solvents may be used singly, or two or more kinds thereof may be used in combination.

The content of the solvent in the composition is preferably such that the total mass (solid content concentration) of the solid content in the composition is 1% to 90% by mass, more preferably 5% to 85% by mass, and even more preferably 10% to 80% by mass, with respect to the total mass of the composition.

### <Curable compound>

The composition may further contain a curable compound that is a curing agent or a main agent not corresponding to the disk-like compound.

The curing agent corresponding to the curable compound is not particularly limited as long as the curing agent is a compound having a functional group selected from a hydroxyl group, an amino group, a thiol group, an isocyanate group, a thioisocyanate group, an aldehyde group, a carboxyl group, an carboxylic acid anhydride group, and a sulfo group, and not having a disk-like structure, but a curing agent suitable for the disk-like compound used as a main agent in the composition is preferable.

For example, in a case where the composition contains a disk-like compound having an oxiranyl group as a main agent, a curing agent having a functional group selected from the group consisting of a hydroxyl group, an amino group, and an carboxylic acid anhydride group is preferably used as the curable compound.

The number of the functional groups contained in the curing agent is not particularly limited, but is preferably 4 or less, and more preferably 3 or less, from a viewpoint of more excellent peel strength of the thermally conductive sheet. The lower limit is not particularly limited, but two or more are preferable.

Examples of the curing agent that is not a disk-like compound include the epoxy resin curing agent described in paragraph 0028 of JP4118691B, the amine-based curing agent, the phenol-based curing agent, and the acid anhydride-based curing agent described in paragraphs 0016 to 0018 of JP2008-013759A, and the amine-based curing agent and the phenol-based curing agent described in paragraphs 0101 to 0150 of JP2013-227451A.

The main agent corresponding to the curable compound is not particularly limited as long as the main agent has a functional group selected from the group consisting of a (meth)acrylic group, a (meth)acrylamide group, an oxiranyl group, an oxetanyl group, and an aziridiyl group, and does not have a disk-like structure, but a main agent suitable for the disk-like compound used as a curing agent in the composition is preferable.

For example, in a case where the composition contains a disk-like compound having a hydroxyl group, an amino group, or an carboxylic acid anhydride group as a functional group, as a curing agent, it is preferable to use a main agent having an oxiranyl group as the curable compound.

The number of the functional groups contained in the main agent is not particularly limited, but is preferably 4 or less, and more preferably 3 or less, from a viewpoint of more excellent peel strength of the thermally conductive sheet. The lower limit is not particularly limited, but two or more are preferable.

The number of the functional groups contained in the main agent is not particularly limited, but is preferably two or more.

The main agent that is not a disk-like compound may be a known epoxy resin monomer and an acrylic resin monomer. Examples of the main agent that is not a disk-like compound include the epoxy resin monomer and the acrylic resin monomer described in paragraph 0028 of JP4118691B, the epoxy compounds described in paragraphs 0006 to 0011 of JP2008-013759A, and the epoxy resin mixture described in paragraphs 0032 to 0100 of JP2013-227451A.

One kind of the curable compounds may be used singly, or two or more kinds thereof may be used in combination.

In a case where the composition contains a curing agent that is not a disk-like compound, the content of the curing agent is preferably 1% to 50% by mass, and more preferably 2% to 20% by mass, with respect to the total mass of the solid content of the composition.

In a case where the composition contains a main agent that is not a disk-like compound, the content of the main agent is preferably 1% to 50% by mass, and more preferably 3% to 30% by mass, with respect to the total mass of the solid content of the composition.

### <Curing accelerator>

The composition may further contain a curing accelerator.

Examples of the curing accelerator include triphenylphosphine, 2-ethyl-4-methylimidazole, boron trifluoride amine complex, 1-benzyl-2-methylimidazole, and a curing accelerator described in paragraph 0052 of JP2012-067225A. In addition to these, examples of the curing accelerator include imidazole-based curing accelerators such as 2-methylimidazole (trade name; 2MZ), 2-undecylimidazole (trade name; C11-Z), 2-heptadecylimidazole (trade name; C17Z), 1,2-dimethylimidazole (trade name; 1.2DMZ), 2-phenylimidazole (trade name; 2PZ), 2-phenyl-4-methylimidazole (trade name; 2P4MZ), 1-benzyl-2-methylimidazole (trade name; 1B2MZ), 1-benzyl-2-phenylimidazole (trade name; 1B2PZ), 1-cyanoethyl-2-methylimidazole (trade name; 2MZ-CN), 1-cyanoethyl-2-undecylimidazole (trade name; C11Z-CN), 1-cyanoethyl-2-phenylimidazolium trimellitate (trade name; 2PZCNS-PW), 2,4-diamino-6-[2'-methylimidazolyl-(1')]-ethyl-s-triazine (trade name; 2MZ-A), 2,4-diamino-6-[2'-undecylimidazolyl-(1')]-ethyl-s-triazine (trade name; C11Z-A), 2,4-diamino-6-[2'-ethyl-4'-methylimidazolyl-(1')]-ethyl-s-triazine (trade name; 2E4MZ-A), 2,4-diamino-6-[2'-methylimidazolyl-(1')]-ethyl-s-triazine isocyanuric acid adduct (trade name; 2MA-OK), 2-phenyl-4,5-dihydroxymethylimidazole (trade name; 2PHZ-PW), 2-phenyl-4-methyl-5-hydroxymethylimidazole (trade name; 2P4MHZ-PW), and 1-cyanoethyl-2-phenylimidazole (trade name; 2PZ-CN) (all produced by SHIKOKU CHEMICALS CORPORATION).

Among them, triphenylphosphine is preferable.

One kind of the curing accelerators may be used singly, or two or more kinds thereof may be used in combination.

In a case where the composition contains a curing accelerator, the content of the curing accelerator is preferably 0.01% to 30% by mass, more preferably 0.01% to 20% by mass, and 0.01% to 10% by mass, with respect to the total mass of the solid content of the composition.

### <Dispersant>

The composition may further contain a dispersant. The composition preferably contains a dispersant from a viewpoint of improving dispersibility of the inorganic particles in the composition and more excellent thermally conductive properties and adhesiveness of the thermally conductive sheet.

The dispersant can be appropriately selected from the dispersants used for the thermally conductive material in the related art. Examples of the dispersant include DISPERBYK-106 (produced by BYK-Chemie GmbH), DISPERBYK-111 (produced by BYK-Chemie GmbH), ED-113 (produced by Kusumoto Chemicals, Ltd.), AJISPER PN-411 (produced by Ajinomoto Fine-Techno Co., Inc.), and REB122-4 (produced by Showa Denko Materials Co., Ltd.).

One kind of the dispersants may be used singly, or two or more kinds thereof may be used in combination.

In a case where the composition contains the dispersant, a content of the dispersant is preferably 0.01% to 20% by mass, and more preferably 0.01% to 10% by mass, with respect to the total mass of the solid content of the composition.

In addition, in a case where the composition contains a dispersant, a ratio of the content of the dispersant to the content of the inorganic particles (content of the dispersant/ content of the inorganic particles) is, by mass ratio, preferably 0.0001 to 10, and more preferably 0.001 to 5.

### <Surface modifier>

The composition may further contain a surface modifier which is a component that surface-modifies inorganic particles (for example, inorganic nitrides and inorganic oxides).

In the present specification, "surface modification" means a state in which an organic substance is adsorbed onto at least a part of a surface of the inorganic particles. A form of the adsorption is not particularly limited, and may be in a bonded state. That is, the surface modification also includes a state in which an organic group obtained by desorbing a part of the organic substance is bonded to the surface of the inorganic particles. The bond may be any one of a covalent bond, a coordinate bond, an ionic bond, a hydrogen bond, a van der Waals bond, or a metallic bond. The surface modification may be performed so that a monolayer is formed on at least a part of the surface. The monolayer is a single-layer film formed by chemical adsorption of organic molecules, and is known as a Self-Assembled MonoLayer (SAM). In the present specification, only a part of the surface of the inorganic particles may be surface-modified, or the entire surface of the inorganic particles may be surface-modified.

In the composition, the inorganic particles may constitute surface-modified inorganic particles together with the surface modifier.

A method for producing the surface-modified inorganic particles is not particularly limited, and examples thereof include a method including a step of bringing the inorganic particles into contact with the surface modifier. The contact between the inorganic particles and the surface modifier is carried out, for example, by stirring in a mixed solution of the inorganic particles, the surface modifier, and the organic solvent.

In addition, the surface-modified inorganic particles may be separately prepared and then the prepared surface-modified inorganic particles may be mixed with a part or all of another component in the composition.

The composition preferably contains an organic silane molecule (preferably a compound having an alkoxysilyl group) as a surface modifier (preferably a surface modifier for inorganic oxides, more preferably a surface modifier for aluminum oxide).

Examples of the organic silane molecule include 3-aminopropyltriethoxysilane, 3-(2-aminoethyl)aminopropyltriethoxysilane, 3-aminopropyltrimethoxysilane, 3-(2-aminoethyl) aminopropyltrimethoxysilane, N-phenyl-3-aminopropyltrimethoxysilane, 3-mercaptotriethoxysilane, and 3-ureidopropyltriethoxysilane.

One kind of the surface modifiers may be used singly, or two or more kinds thereof may be used in combination.

In a case where the composition contains a surface modifier, a mass ratio (content of surfactant/content of inorganic particles) of the content of the surface modifier (preferably an organic silane molecule) with respect to the content of the inorganic particles (preferably an inorganic oxide such as aluminum oxide) is preferably 0.00001 to 0.1, and more preferably 0.00005 to 0.05 from a viewpoint of more excellent dispersibility of the inorganic particles.

### <Polymerization initiator>

The composition may further contain a polymerization initiator.

Examples of the polymerization initiator include the polymerization initiators described in paragraph 0062 of JP2010-125782A and paragraph 0054 of JP2015-052710A. In a case where the composition contains a disk-like compound having a (meth)acrylic group or a (meth)acrylamide group, or other main agent, it is preferable that the composition contains the polymerization initiator.

One kind of the polymerization initiators may be used singly, or two or more kinds thereof may be used.

In a case where the composition contains a polymerization initiator, the content of the polymerization initiator in the composition is preferably 0.01% to 30% by mass, more preferably 0.01% to 20% by mass, and even more preferably 0.01% to 10% by mass, with respect to the total mass of the solid content of the composition.

### [Method for producing composition]

The method for producing the composition is not particularly limited, and a known method can be adopted. For example, each of the aforementioned component (disk-like compound, specific polymer, inorganic particles, solvent, and optional component) can be produced by mixing by a known method. When mixing each component, each component may be mixed at a time or mixed sequentially.

### [Thermally conductive sheet]

### [Method for producing thermally conductive sheet]

The thermally conductive sheet according to the embodiment of the present invention is formed using the composition according to the embodiment of the present invention.

The method for producing the thermally conductive sheet is not particularly limited, but for example, it is preferable to cure the composition according to the embodiment of the present invention to obtain a thermally conductive sheet containing the cured product. As a method for curing the composition, a method suitable for the kind of the disk-like compound and other components contained in the composition may be appropriately selected, but a thermosetting reaction is preferable.

A heating temperature during the thermosetting reaction is not particularly limited. For example, the thermosetting reaction may be carried out in a range of 50°C to 250°C. In addition, when performing the thermosetting reaction, a heating treatment at different temperatures may be performed a plurality of times.

The curing treatment is preferably performed on the composition which is formed in a film shape, a sheet shape, or a plate shape. Specifically, for example, the composition may be applied to form a film, and the curing treatment may be performed on the obtained coating film. At that time, press working may be performed.

In addition, the curing treatment may be completed at a time point when the composition is in a semi-cured state. After disposing the thermally conductive sheet in the semi-cured state so as to be in contact with a device such as a device to be used, main curing such as heating may be carried out to further promote the curing of the thermally conductive sheet. It is also preferable to adhere the device and the thermally conductive sheet by the main curing carried out by heating or the like.

For the method for producing a thermally conductive sheet using the curing reaction, "Highly thermally conductive composite material" (CMC Publishing, written by Yutaka Takezawa) on pages 63 to 78 can be referred to.

### [Characteristics of thermally conductive sheet]

The shape of the thermally conductive sheet is not particularly limited, but may be a shape having a planar spread, and examples thereof may be a shape called a film shape, a sheet shape, or a plate shape.

The thermally conductive sheet has excellent thermally conductive properties, and can improve the efficiency of heat transfer between objects in contact with both main surfaces of the thermally conductive sheet.

The thermal conductivity in a film thickness direction (direction perpendicular to the main surface) of the thermally conductive sheet is not particularly limited, but is preferably 3 W/mK or greater, more preferably 5 W/mK or greater, and even more preferably 8 W/mK or greater. The upper limit is not particularly limited, but is 30 W/mK or less in many cases.

The thermal conductivity in the film thickness direction of the thermally conductive sheet can be calculated by measuring the thermal diffusivity, specific gravity, and specific heat in the film thickness direction of the thermally conductive sheet using a known measuring device and multiplying thereof.

### <Film thickness>

The film thickness of the thermally conductive sheet is not particularly limited, but is preferably 60 µm or greater, more preferably 100 µm or greater, and even more preferably 150 µm or greater, from a viewpoint of more excellent insulating properties in the film thickness direction.

The upper limit of the film thickness of the thermally conductive sheet is not particularly limited, but is preferably 5,000 µm or less, and more preferably 3,000 µm or less.

The film thickness of the thermally conductive sheet is the average film thickness. The method for measuring the film thickness of the thermally conductive sheet is not particularly limited, and a method of measuring the film thickness of several optional points of the thermally conductive sheet using a known film thickness measuring device and calculating the average value thereof is exemplified.

### <Toughness parameter>

From a viewpoint of more excellent peel strength, the toughness parameter obtained by the following test method 1 of the thermally conductive sheet is preferably 15 MPa·% or greater, more preferably 30 MPa·% or greater, and even more preferably 45 MPa·% or greater. The upper limit of the toughness parameter is not particularly limited, but is preferably 100 MPa·% or less.

Test method 1: A thermally conductive sheet is subjected to a tensile test at a tensile speed of 1 mm/min using a tensile tester in a temperature environment of 25°C, and stress and strain of the thermally conductive sheet are measured. From the obtained measurement results, a stress-strain curve is prepared with stress on a vertical axis and strain on a horizontal axis. Of the obtained stress-strain curve, an area of a figure surrounded by the stress-strain curve in a section from the origin to the breaking point, the vertical line drawn from the breaking point to the horizontal axis, and the horizontal axis are integrated, and the calculated integration value (unit: MPa·%) is used as the toughness parameter of the thermally conductive sheet.

Examples of the tensile tester include a Tensilon universal material tester (product name "RTC-1225A", produced by A & D Co., Ltd.).

In addition, in the tensile test, the thermally conductive sheet cut into strips of 10 mm × 45 mm is used as a test sample.

### [Use of thermally conductive sheet]

The thermally conductive sheet can be used as a heat dissipation material such as a heat dissipation sheet, and can be used for heat dissipation applications of various devices. More specifically, by disposing the thermally conductive sheet on the device to produce a device with the thermally conductive sheet, the heat generated from the device can be efficiently dissipated through the thermally conductive sheet.

Since the thermally conductive sheet has sufficient thermally conductive properties and has high heat resistance, the thermally conductive sheet is suitable for heat dissipation uses of a power semiconductor device used in various electrical machines such as a personal computer, a general household electric appliance, and an automobile.

In addition, the thermally conductive sheet has sufficient thermally conductive properties even in a semi-cured state, and thus can also be used as a heat dissipation material which is disposed in a portion where light for photocuring is hardly reached, such as a gap between members of various devices. In addition, the thermally conductive sheet can also be used as an adhesive layer having thermally conductive properties.

The thermally conductive sheet may be used in combination with members other than the members formed of the composition.

For example, the thermally conductive sheet may be combined with a sheet-shaped support other than the thermally conductive sheet.

Examples of the sheet-shaped support include a plastic film, a metal film, and a glass plate. Examples of a material for the plastic film include polyester such as polyethylene terephthalate (PET), polycarbonate, an acrylic resin, an epoxy resin, polyurethane, polyamide, polyolefin, a cellulose derivative, and silicone. Examples of the metal film include a copper film.

### <Thermally conductive sheet with adhesive layer or pressure sensitive adhesive layer>

An adhesive layer and/or a pressure sensitive adhesive layer may be combined with the thermally conductive sheet.

For example, a thermally conductive sheet (thermally conductive multilayer sheet) including a thermally conductive sheet and an adhesive layer or a pressure sensitive adhesive layer provided on one surface or both surfaces of the thermally conductive sheet may be prepared.

By bonding the thermally conductive material to an object to which heat is to be transferred, such as a device, via such an adhesive layer and/or a pressure sensitive adhesive layer, the thermally conductive multilayer sheet can achieve firmer bonding between the thermally conductive sheet and the object.

On one surface or both surfaces of the thermally conductive sheet, only one of the adhesive layer and the pressure sensitive adhesive layer may be provided, or the both of the adhesive layer and the pressure sensitive adhesive layer may be provided. The adhesive layer may be provided on one surface of the thermally conductive sheet, and the pressure sensitive adhesive layer may be provided on the other surface thereof. In addition, on one surface or both surfaces of the thermally conductive sheet, the adhesive layer and/or the pressure sensitive adhesive layer may be partially provided, or may be provided over the entire surface.

The thermally conductive sheet may be in a semi-cured state (semi-cured film), and the thermally conductive sheet in the thermally conductive multilayer sheet may be in a semi-cured state. The adhesive layer in the thermally conductive multilayer sheet may be cured, may be in a semi-cured state, or may be in an uncured state.

### (Adhesive layer)

Examples of the adhesive layer include a layer containing at least one kind of compound (a resin and/or a low-molecular-weight body) having adhesiveness.

The adhesive layer may further contain other components such as a filler, if necessary.

As the compound having adhesiveness, a compound having insulating properties, adhesiveness, and/or flexibility, during adhesion with the object, is preferable.

In particular, from a viewpoint of the adhesiveness and the insulating properties, it is preferable to contain at least one kind selected from the group consisting of a polyimide resin, a modified polyimide resin, a polyamide imide resin, a modified polyamide imide resin, and an epoxy compound.

The epoxy compound may be an epoxy resin containing an acryl-modified rubber.

Examples of the polyimide resin and the modified polyimide resin include products represented by UPICOAT FS-100L (produced by UBE INDUSTRIES, LTD.), SEMICOFINE SP-300, SP-400, and SP-800 (produced by TORAY INDUSTRIES, INC.), U-IMIDE SERIES (produced by UNITIKA LTD.), and the like.

Examples of the polyamide imide resin or the modified polyamide imide resin include KS SERIES (produced by Showa Denko Materials Co., Ltd.), VYLOMAX SERIES (produced by TOYOBO CO., LTD.), and TORLON (produced by SOLVAY SPECIAL POLYMERS JAPAN K. K.).

Among them, from the viewpoints of high heat resistance and high adhesiveness, it is preferable to use a modified polyamide imide resin represented by KS SERIES (produced by Showa Denko Materials Co., Ltd.).

One kind of the polyimide resin, the polyamide imide resin, and the modified polyamide imide resin, which are used for the adhesive layer, may be used singly, or two or more kinds thereof may be used.

Moreover, these resins are generally in a varnish state where the resin is dissolved in a solvent, and can also be used as an adhesive layer by applying the resin directly to a support such as a PET film and drying the solvent to form a film.

Furthermore, an epoxy compound may be used as the compound having adhesiveness. For example, an epoxy composition containing an epoxy compound, a curing agent therefor, and a curing accelerator may be used as the adhesive layer. It is also preferable that glycidyl acrylate is added to the epoxy composition.

For details of the epoxy composition, for example, the descriptions of JP2002-134531A, JP2002-226796A, and JP2003-221573A can also be referred to.

The epoxy compound used for the adhesive layer is not particularly limited as long as the epoxy compound is cured to exhibit an adhesive action. Examples of the epoxy compound include an epoxy compound which is a bisphenol A-type or bisphenol F-type liquid having a molecular weight of 500 or less. These epoxy compounds are preferable in that the fluidity at the time of laminating can be improved. A polyfunctional epoxy compound may be added to the adhesive layer for the purpose of increasing the Tg (glass transition temperature). Examples of the polyfunctional epoxy compound include a phenol novolac-type epoxy compound and a cresol novolac-type epoxy compound.

As the epoxy compound used for the adhesive layer, an epoxy compound that can be used as the disk-like compound or curable compound may be used.

Examples of the curing agent for the epoxy compound include polyamide, polyamine, an acid anhydride, polysulfide, boron trifluoride and a phenolic compound (a phenol novolac resin, and bisphenol A, bisphenol F, bisphenol S, or the like, which is a compound having two or more phenolic hydroxyl groups in one molecule). From the viewpoint of excellent electrolytic corrosion resistance during moisture absorption, it is also preferable to use a phenol novolac resin, a bisphenol novolac resin, or a cresol novolac resin, which is a phenolic compound.

In addition, as the curing agent, a phenolic compound that can be used as the disk-like compound or curable compound may be used.

In a case where the curing agent is used, it is preferable to use a curing accelerator together with the curing agent. It is also preferable to use imidazole compound as the curing accelerator. Examples of the imidazole compounds include 2-methylimidazole, 2-ethyl-4-methylimidazole, 1-cyanoethyl-2-phenylimidazole, and 1-cyanoethyl-2-phenylimidazolium trimellitate. The imidazole compounds are commercially available, for example, from SHIKOKU CHEMICALS CORPORATION under the trade names of 2E4MZ, 2PZ-CN, and 2PZ-CNS.

As the curing accelerator, a compound (triphenylphosphine or the like) described as the curing accelerator that may be contained in the composition may be used.

It is also preferable that the epoxy compound used for the adhesive layer is used in combination with a high-molecular-weight resin compatible with the epoxy compound.

Examples of the high-molecular-weight resin compatible with the epoxy compound include a high-molecular-weight epoxy compound, a highly polar functional group-containing rubber, and a highly polar functional group-containing reactive rubber.

Examples of the highly polar functional group-containing reactive rubber include an acryl-modified rubber obtained by adding a highly polar functional group such as a carboxyl group to an acrylic rubber.

Here, being compatible with the epoxy compound means a property of forming a homogeneous mixture without being divided into two or more phases by being separated from the epoxy compound after curing.

A weight-average molecular weight of the high-molecular-weight resin is not particularly limited. From the viewpoints that tackiness of the adhesive in a B stage is reduced, and flexibility during curing is improved, the weight-average molecular weight of the high-molecular-weight resin is preferably 30,000 or greater.

The high-molecular-weight epoxy compound includes a high-molecular-weight epoxy compound having a molecular weight of 30,000 to 80,000, and an ultra-high-molecular-weight epoxy compound having a molecular weight of greater than 80,000 (refer to JP1995-059617B (JP-H7-059617B), JP1995-059618B (JP-H7-059618B), JP1995-059619B (JP-H7-059619B), JP1995-059620B (JP-H7-059620B), JP1995-064911B (JP-H7-064911B), and JP1995-068327B (JP-H7-068327B)), both of which are produced by Showa Denko Materials Co., Ltd.

As a carboxyl group-containing acrylic rubber, which is the highly polar functional group-containing reactive rubber, HTR-860P (trade name) is sold, for example, by Nagase ChemteX Corporation.

In a case where the high-molecular-weight resin which is compatible with the epoxy compound and has a weight-average molecular weight of 30,000 or greater is used, and the resin constituting the adhesive layer is 100 parts by mass, the addition amount thereof is preferably 10 parts by mass or greater. The upper limit is not particularly limited, but is preferably 40 parts by mass or less.

In a case where the high-molecular-weight resin is 10 parts by mass or greater, improvement in flexibility of a phase (hereinafter, referred to as an epoxy compound phase) containing the epoxy compound as a main component, improvement in tackiness, and/or suppression of cracks is likely to be achieved, and insulating properties are less likely to deteriorate. When the high-molecular-weight resin is 40 parts by mass or less, the Tg of the epoxy compound phase can be improved.

A weight-average molecular weight of the high-molecular-weight epoxy compound is preferably 20,000 or greater and 500,000 or less. Within this range, the strength and/or flexibility in a sheet state and/or a film state is improved, and tackiness is also likely to be suppressed.

### - Silane coupling agent -

A silane coupling agent may be blended in the adhesive layer in order to improve an interfacial bond between different kinds of materials.

Examples of the silane coupling agent include γ-glycidoxypropyltrimethoxysilane, γ-mercaptopropyltrimethoxysilane, γ-aminopropyltriethoxysilane, γ-ureidopropyltriethoxysilane, and N-β-aminoethyl-γ-aminopropyltrimethoxysilane.

Among them, from the viewpoint of adhesive strength, γ-mercaptopropyltrimethoxysilane or γ-aminopropyltriethoxysilane is preferable.

In a case where the adhesive layer contains the silane coupling agent, a blending amount thereof is preferably 0.1 to 10 parts by mass with respect to 100 parts by mass of the compound having adhesiveness, from the viewpoint of an effect of addition and/or an influence on heat resistance.

### -Filler-

The adhesive layer may contain a filler (preferably an inorganic filler).

As the adhesive layer contains the filler, the handleability or thermally conductive properties of the adhesive layer are improved. In addition, as the adhesive layer contains a filler, flame retardancy is imparted to the adhesive layer, melt viscosity of the adhesive layer is adjusted, thixotropic property is imparted to the adhesive layer, and/or surface hardness is improved.

In a case where the adhesive layer contains a filler, the content thereof is not particularly limited, but 20 parts by volume or greater is preferable, and from a viewpoint of the blending effect, 30 parts by volume or greater is more preferable, with respect to 100 parts by volume of the compound having adhesiveness contained in the adhesive layer. Although the upper limit is not particularly limited, from a viewpoint of optimizing the storage elastic modulus of the adhesive layer, improving the adhesiveness, and/or achieving suppression of void to suppress deterioration of the insulating properties, 50 parts by volume or less is preferable with respect to 100 parts by volume of the compound having the adhesiveness contained in the adhesive layer.

Examples of the inorganic filler include aluminum hydroxide, magnesium hydroxide, calcium carbonate, magnesium carbonate, calcium silicate, magnesium silicate, calcium oxide, magnesium oxide, alumina (aluminum oxide), aluminum nitride, aluminum borate whisker, boron nitride, crystalline silica, amorphous silica, silicon nitride, talc, mica, and barium sulfate.

Among them, from the viewpoints that heat dissipating properties are favorable due to high thermal conductivity, impurities are likely to be controlled, and/or heat resistance and insulating properties are favorable, alumina, boron nitride, or aluminum nitride is preferable.

One kind of the fillers may be used singly, or two or more kinds thereof may be used.

An average particle diameter of the filler contained in the adhesive layer is not particularly limited. For example, from a viewpoint of thermally conductive properties, the average particle diameter is preferably 0.1 to 10 µm, and more preferably 0.2 to 5 µm.

From the viewpoint of balancing adhesiveness and thermally conductive properties, a content of the filler in the adhesive layer is preferably 50% by volume or less (for example, 20% by volume or greater and 50% by volume or less) with respect to the total volume of the adhesive layer.

From the viewpoints of adhesive strength and thermal conductivity, it is particularly preferable that the adhesive layer contains, as the compound having adhesiveness, at least one kind selected from the group consisting of the epoxy compound and the modified polyamide imide resin, and contains, as the filler, at least one kind selected from the group consisting of alumina and silicon oxide, the content of the filler is 20 parts by volume or greater and 50 parts by volume or less with respect to 100 parts by volume of the compound having adhesiveness, and the average particle diameter of the filler is 0.2 to 5 µm.

The film thickness of the adhesive layer is preferably 1 to 16 µm, more preferably 2 to 15 µm, even more preferably 3 to 14 µm, and particularly preferably 4 to 12 µm, from the viewpoints of thermal conductivity and adhesiveness.

The film thickness of the adhesive layer can be measured using a micrometer, a stylus-type film thickness meter, and a needle-type film thickness meter.

### (Pressure sensitive adhesive layer)

As a material for the pressure sensitive adhesive layer, any material having the required heat resistant performance and thermally conductive performance such as various pressure sensitive adhesives and/or thermosetting materials can be used without particular limitation. In addition, a pressure sensitive adhesive of which the thermally conductive properties are improved by mixing various thermally conductive fillers in the pressure sensitive adhesive layer may be used.

Examples of the pressure sensitive adhesive, which forms the pressure sensitive adhesive layer, include an acrylic pressure sensitive adhesive, an olefin-based pressure sensitive adhesive, a silicone-based pressure sensitive adhesive, a natural rubber-based pressure sensitive adhesive, and a synthetic rubber-based pressure sensitive adhesive.

From the viewpoint that outgas is less likely to be generated, in a case where a thermally conductive sheet is used in the vicinity of a semiconductor in an electronic machine, an acrylic pressure sensitive adhesive or an olefin-based pressure sensitive adhesive is preferable. Moreover, from the viewpoint of heat resistance, a silicone-based pressure sensitive adhesive containing a silicone resin as a main raw material is preferable.

Furthermore, the "pressure sensitive adhesive containing a silicone resin as a main raw material" is a pressure sensitive adhesive containing 60% by mass or greater (preferably 80% by mass or greater) of the silicone resin.

Examples of the pressure sensitive adhesive containing a silicone resin as a main raw material include a peroxide crosslinking (curing)-type silicone-based pressure sensitive adhesive and an addition reaction-type silicone-based pressure sensitive adhesive. Among them, from the viewpoints that the thickness accuracy is high in a case of being formed into a thin layer, and the pressure sensitive adhesive layer can be easily formed by a transfer method, an addition reaction-type silicone-based pressure sensitive adhesive is preferable.

Examples of the addition reaction-type silicone-based pressure sensitive adhesive include pressure sensitive adhesives which contain a silicone rubber and a silicone resin, and further contain, if necessary, an additive such as a crosslinking agent, a filling agent, a plasticizer, an antiaging agent, an antistatic agent, and/or a colorant (a pigment or a dye).

The silicone rubber is not particularly limited as long as the silicone rubber is a silicone-based rubber component, but a silicone rubber, which contains an organopolysiloxane (in particular, organopolysiloxane having methylphenylsiloxane as a main constitutional unit) having a phenyl group, is preferable. Various functional groups such as a vinyl group may be introduced into organopolysiloxane in such a silicone rubber, if necessary.

The silicone resin is not particularly limited as long as the silicone resin is a silicone-based resin used for a silicone-based pressure sensitive adhesive, and examples thereof include a silicone resin which contains organopolysiloxane consisting of a (co)polymer having at least one kind of unit selected from the group consisting of a unit consisting of a constitutional unit "R₃SiO_{1/2}", a unit consisting of a constitutional unit "SiO₂", a unit consisting of a constitutional unit "RSiO_{3/2}", and a unit consisting of a constitutional unit "R₂SiO". Furthermore, R in the constitutional unit represents a hydrocarbon group or a hydroxyl group.

Examples of the acrylic pressure sensitive adhesive include a homopolymer and a copolymer of (meth)acrylic acid and/or (meth)acrylic acid ester.

Among them, from the viewpoint of more excellent flexibility, chemical stability, workability, and/or controllability of pressure sensitive adhesive properties, the acrylic pressure sensitive adhesive is preferably a poly(meth)acrylic acid ester-based high-molecular-weight compound containing monomer such as butyl acrylate and 2-ethylhexyl acrylate as a main raw material component.

The high-molecular-weight compound is preferably a copolymer having a structure in which a polar group such as a -COOH group, a -CN group, and an -OH group is introduced by copolymerizing one or more monomers selected from butyl acrylate, ethyl acrylate, 2-ethylhexyl acrylate, and the like with acrylic acid, acrylonitrile, and/or hydroxyethyl acrylate.

In addition, a crosslinked structure may be introduced into the acrylic pressure sensitive adhesive as long as flexibility is not impaired. By introducing the crosslinked structure, long-term close adhesion retaining properties and film hardness are likely to be improved. For example, the crosslinked structure can be introduced into a polymer having a polar group such as an -OH group by reacting, with the polar group, a compound having a functional group, such as a plurality of isocyanate groups and epoxy groups, which is bonded to the polar group.

### Examples

Hereinafter, the present invention will be described in more detail based on Examples. The materials, the amount and proportion of the materials used, the details of treatments, and the procedure of treatments shown in the following Examples can be appropriately changed within a range that does not depart from the gist of the present invention.

### [Each component]

Each component used in the preparation of the compositions of each Example and each Comparative Example is shown below.

### [disk-like compound]

Disk-like compounds used in Examples or Comparative Examples will be shown below.

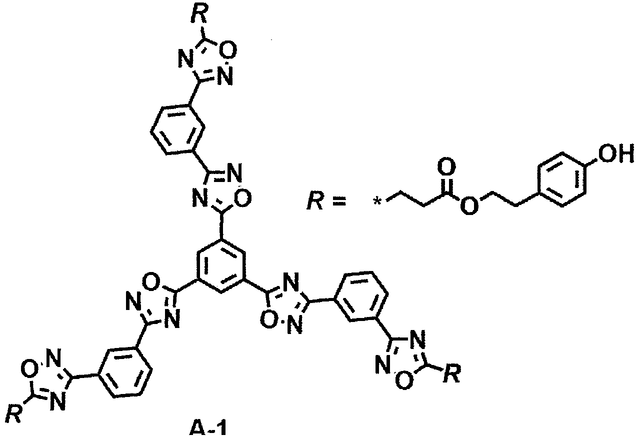

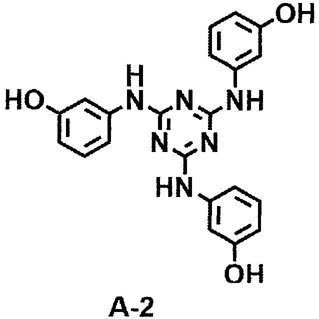

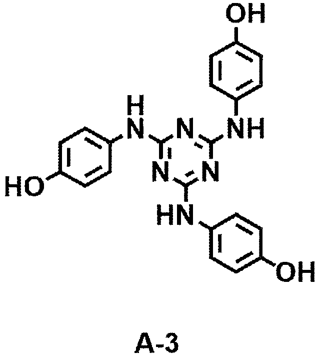

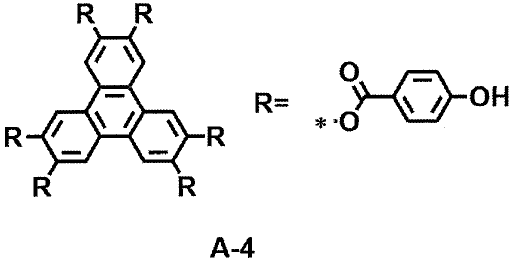

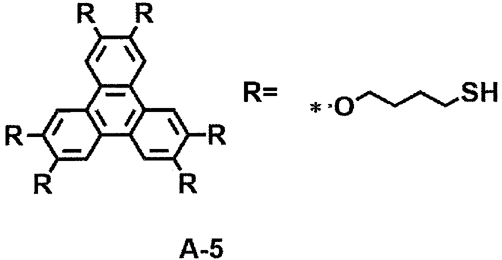

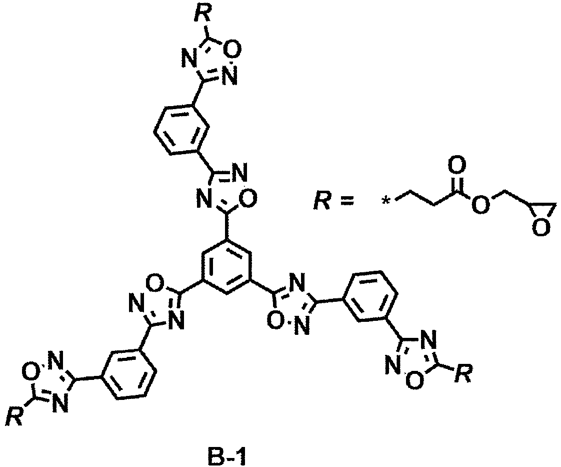

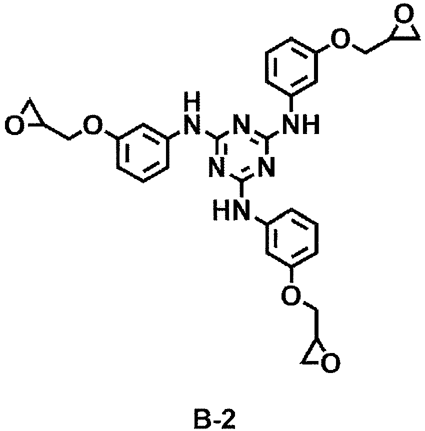

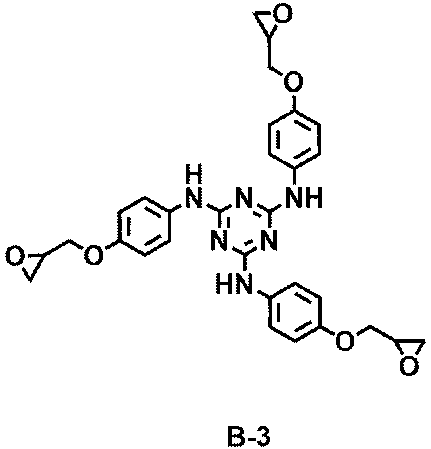

The disk-like compounds A-1 to A-5 and B-1 to B-3 are all compounds represented by Formula (D4) or (D16), and the number of atoms between both ends of the divalent linking groups is 19, 4, 5, 6, 5, 14, 6, and 7, respectively.

### [Curable compound]

Curable compounds used in Examples and Comparative Examples will be shown below. The compounds C-1 to C-6 are curing agents that are not disk-like compounds, and the compounds D-1 to D-4 are main agents that are not disk-like compounds.

Compound C-6 is "MEH-7500" produced by Meiwa Plastic Industries, Ltd.

In addition, compound D-1 is "YX-4000" produced by Mitsubishi Chemical Co., Ltd., compound D-2 is a mixture of two kinds of epoxy compounds (trade name "Epototo ZX-1059", produced by Toto Kasei Co., Ltd.), compound D-3 is "Denacol EX-201" produced by Nagase ChemteX Corporation, and compound D-4 is "EPPN-501HY" produced by Nippon Kayaku Co., Ltd.

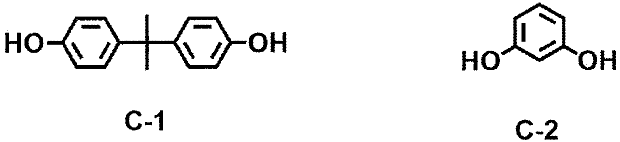

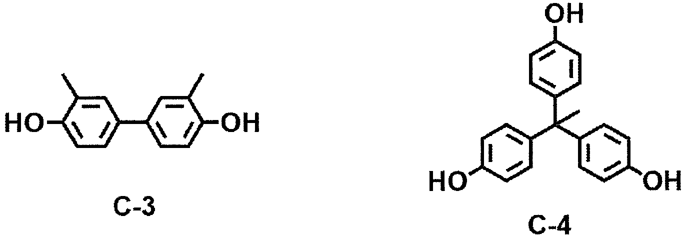

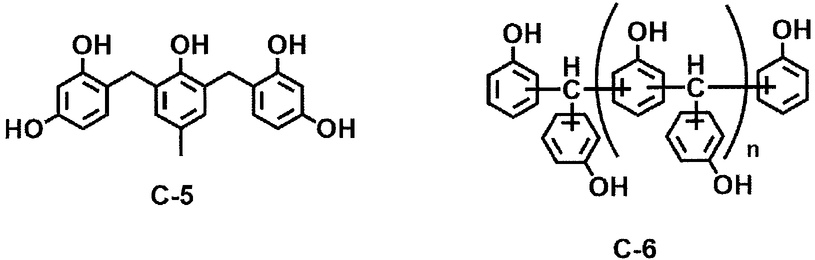

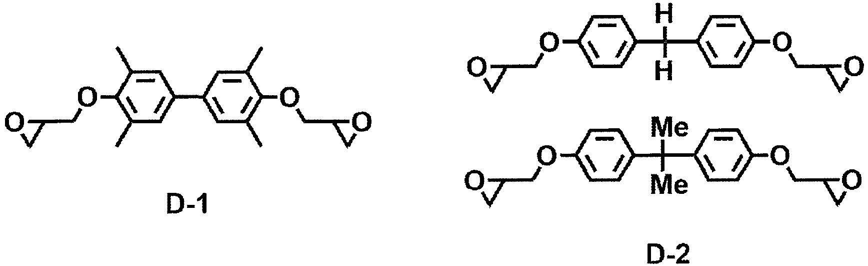

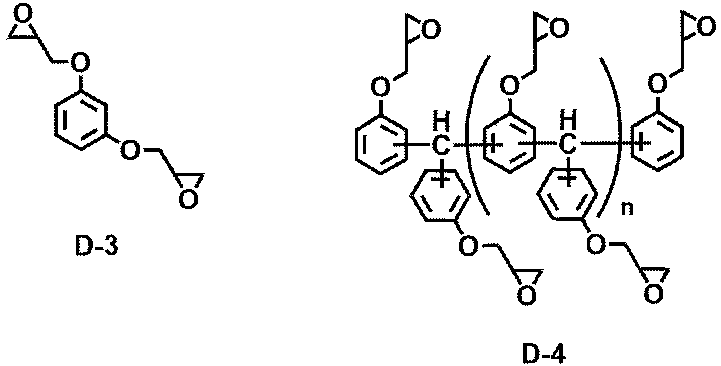

### [Specific polymer]

In Examples and Comparative Examples, the following compounds E-1 to E-8 were used as specific polymers.
"E-1": produced by Aldrich (weight average molecular weight Mw = 35,000)
"E-2": "Sumika Excel 5003 PS" produced by Sumitomo Chemical Co., Ltd.
"E-3": produced by Aldrich (weight average molecular weight Mw = 20,800)
"E-4": produced by Aldrich (melt index 18 g/10 min)
"E-5": produced by Aldrich (weight average molecular weight Mw = 30,000)
"E-6": produced by Aldrich (weight average molecular weight Mw = 45,000)
"E-7": produced by Aldrich (weight average molecular weight Mw = 15,000)
"E-8": produced by Aldrich (number average molecular weight Mn = 3,800, acrylonitrile 8 to 12 wt%)

The structural formulas of the compounds E-1 to E-8 are shown below.

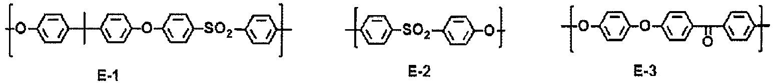

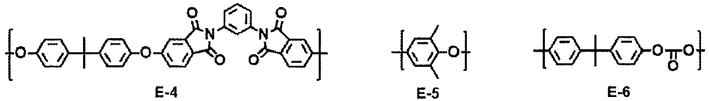

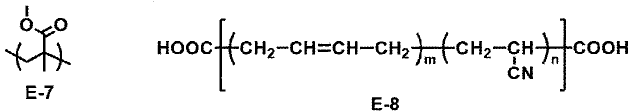

### [Inorganic particles]

The inorganic particles used in Examples are shown below.
"HP40 MF100": Aggregation-shaped boron nitride (average particle diameter: 40 µm, produced by Mizushima Ferroalloy Co., Ltd.)
"AA-3": Aluminum oxide (average particle diameter: 3 µm, produced by Sumitomo Chemical Co., Ltd.)
"AA-04": Aluminum oxide (average particle diameter: 0.4 µm, produced by Sumitomo Chemical Co., Ltd.)
"SP-3": Scaly boron nitride (average particle diameter: 4 µm, produced by Denka Co., Ltd.)

In the table below, the "configuration" column of the inorganic particles means that the inorganic particles used in each Example or each Comparative Example had any of the following configurations.
"IP-1": HP-40 MF100 only
"IP-2": A mixture of HP-40 MF100/AA-3/AA-04 = 84/11/5 (mass ratio)
"IP-3": A mixture of HP-40 MF100/AA-3/AA-04 = 77/16/7 (mass ratio)
"IP-4": A mixture of HP-40 MF100/AA-3/AA-04 = 70/21/9 (mass ratio)
"IP-5": A mixture of HP-40 MF100 / AA-3 / AA-04 = 58/29/13 (mass ratio)
"IP-6": A mixture of HP-40 MF100/SP-3 = 99/1 (mass ratio)
"IP-7": A mixture of HP-40 MF100/SP-3 = 95/5 (mass ratio)
"IP-8": A mixture of HP-40 MF100/SP-3 = 90/10 (mass ratio)
"IP-9": A mixture of HP-40 MF100/SP-3 = 85/15 (mass ratio)

### [Curing accelerator]

Triphenylphosphine (PPh₃) was used as a curing accelerator.

### [Dispersant]

DISPERBYK-106 (polymer salt having an acidic group) was used as a dispersant.

### [Surface modifier]

The following compound (organic silane molecule) was used as a surface modifier for inorganic particles (aluminum oxide).

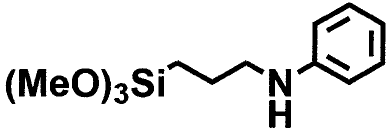

### [Solvent]

Cyclopentanone was used as a solvent.

### [Examples 1 to 53, Comparative Examples 1 to 4]

### [Preparation of composition]

A curing liquid was prepared by blending the disk-like compound shown in the table below and an optional curable compound in the addition amount shown in the table below.

The entire amount of the obtained curing liquid, a solvent, a dispersant, an optional surface modifier for aluminum oxide, and a curing accelerator were mixed in this order, and then inorganic particles were added. The obtained mixture was treated for 5 minutes with a rotating and revolving mixer (produced by THINKY CORPORATION, AWATORI RENTARO ARE-310) to obtain a composition (composition for forming a thermally conductive sheet) of each Example or Comparative Example.

Here, the addition amount of the solvent was set such that the concentration of the solid content in the composition was 50% to 80% by mass.

The concentration of the solid content in the composition was adjusted for each composition within the above range so that the viscosity of the composition was about the same.

The dispersant, the inorganic particles and the curing accelerator were added in the addition amount shown in the table below.

Regarding the addition amount of the surface modifier for aluminum oxide, the content of the surface modifier for aluminum oxide in the composition was 0.2% by mass with respect to the content of aluminum oxide (total content of AA-3 and AA04). In a case where the composition did not contain aluminum oxide as inorganic particles, no surface modifier for aluminum oxide was used.

### [Preparation and evaluation of thermally conductive sheet]

### <Preparation of semi-cured sheet>

The obtained composition was uniformly applied onto a release surface of a release-treated polyester film (NP-100A, produced by PANAC CO., LTD., film thickness of 100 µm) by using an applicator, and left to stand at 120°C for 5 minutes to obtain a polyester film with a coating film.

Two such polyester films with a coating film were prepared, and the two polyester films with a coating film were bonded such that the coating film surfaces are in contact with each other. The obtained laminate was heat-pressed under air (hot plate temperature 65°C, pressure 20 MPa, 1 minute) to prepare a sheet in a semi-cured state (semi-cured sheet) sandwiched between the two polyester films.

<Preparation of semi-cured multilayer sheet>

### (Preparation of adhesive layer film 1: epoxy-based adhesive layer, no filler)

21.6 parts by mass of the disk-like compound B-3, 13.3 parts by mass of the disk-like compound A-1 as a curing agent, 0.21 parts by mass of triphenylphosphine (PPh₃) as a curing accelerator, and 64.9 parts by mass of cyclopentanone were mixed to obtain a coating liquid 1.

The obtained coating liquid 1 was uniformly applied onto a release surface of a release-treated polyester film (NP-100A, produced by PANAC CO., LTD., film thickness of 100 µm) by using an applicator, and left to stand at 120°C for 5 minutes to obtain an adhesive layer film 1 which is a polyester film with a coating film of the coating liquid 1. At this time, the coating amount of the coating liquid 1 was adjusted so that the film thickness of the adhesive layer 1 formed by curing the coating film of the coating liquid 1 was 5 µm.

### (Preparation of adhesive layer film 2: epoxy-based adhesive layer, with filler)

21.6 parts by mass of the disk-like compound B-3, 13.3 parts by mass of the disk-like compound A-1 as a curing agent, 0.21 parts by mass of triphenylphosphine (PPh₃) as a curing accelerator, 35 parts by mass of the "AA-04" (aluminum oxide), and 100 parts by mass of cyclopentanone were mixed to obtain a coating liquid 2.

An adhesive layer film 2 which is a polyester film with a coating film of the coating liquid 2 was obtained according to the method for preparing the adhesive layer film 1, except that the coating liquid 2 was used instead of the coating liquid 1.

### (Preparation of adhesive layer film 3: acrylic acid ester copolymer resin, no filler)

An acrylic acid ester copolymer resin (HTR-280DR, produced by Nagase ChemteX Corporation, butyl acrylate /acrylonitrile/acrylic acid copolymer, weight average molecular weight (Mw): 900,000, glass transition temperature (Tg): 30.9°C, volume resistivity > 10¹³ Ω·m, 15% by mass toluene solution) was diluted with a mixed solvent of methyl ethyl ketone and toluene to obtain a coating liquid 3.

An adhesive layer film 3 which is a polyester film with a coating film of the coating liquid 3 was obtained according to the method for preparing the adhesive layer film 1 except that the coating liquid 3 was used instead of the coating liquid 1.

The layer formed of the acrylic acid ester copolymer resin is a pressure sensitive adhesive layer, but in the examples of the present specification, it is referred to as an adhesive layer for convenience.

### (Preparation of semi-cured multilayer sheets 1 to 3)

Two polyester films were peeled off from the semi-cured sheet with a polyester film obtained in the <Preparation of semi-cured sheet>. The two adhesive layer films 1 prepared by the method were bonded to both surfaces of the obtained semi-cured sheet so that the coating film of the coating liquid 1 was in contact with the semi-cured sheet. The obtained laminate was treated using a laminator under the conditions of a temperature of 120°C, a pressure of 0.7 MPa, a degree of vacuum of ≤1 kPa, and a time of 15 seconds to obtain a semi-cured multilayer sheet 1 having a layer configuration of the polyester film/adhesive layer 1 in a semi-cured state/semi-cured sheet/adhesive layer 1 in a semi-cured state/polyester film.

A semi-cured multilayer sheet 2 having a layer configuration of the polyester film/adhesive layer 2 in a semi-cured state/semi-cured sheet/adhesive layer 2 in a semi-cured state/polyester film was obtained according to the method for preparing the semi-cured multilayer sheet 1 except that the two adhesive layer films 2 were used instead of the two adhesive layer films 1.

In addition, a semi-cured multilayer sheet 3 having a layer configuration of the polyester film/adhesive layer 3 in a semi-cured state/semi-cured sheet/adhesive layer 3 in a semi-cured state/polyester film was obtained by the method for preparing the semi-cured multilayer sheet 1 except that the two adhesive layer films 3 were used instead of the two adhesive layer films 1.

Using the compositions of each Example and each Comparative Example having the compositions shown in Tables 1 and 2 described later, a semi-cured sheet or a semi-cured multilayer sheet was prepared according to the preparation method, and using the obtained semi-cured sheet or the semi-cured multilayer sheet, a thermally conductive sheet was prepared by the method described below, and each evaluation test of toughness, peel strength, and thermally conductive properties was performed on the obtained thermally conductive sheet.

Hereinafter, the method for preparing a thermally conductive sheet, and each test method of toughness, peel strength, and thermally conductive properties of the obtained thermally conductive sheet will be described.

In the following description, a method for preparing a thermally conductive sheet using a semi-cured sheet and each test method will be described, but in Examples 17 to 19, 22 to 23, and 28 to 29, a thermally conductive sheet was prepared using semi-cured multilayer sheets 1 to 3 having any of adhesive layers 1 to 3 shown in Tables 1 and 2 instead of the semi-cured sheet, and each evaluation test was performed using the obtained thermally conductive sheet with an adhesive layer.

### <Toughness evaluation>

A semi-cured sheet prepared by the method was heat-pressed under air (treated at a hot plate temperature of 180°C and a pressure of 20 MPa for 5 minutes, then treated at a hot plate temperature of 180°C in a non-pressurized state for 90 minutes) to cure the sheet, and thereby a resin sheet sandwiched between two polyester films was prepared. The polyester films on both surfaces of the resin sheet were peeled off to obtain a thermally conductive sheet having an average film thickness of 200 µm.

The obtained thermally conductive sheet was cut into strips of 10 mm × 45 mm to prepare a sample for a tensile test. The obtained sample was subjected to a tensile test under the following measurement conditions using a Tensilon universal material testing machine (product name "RTC-1225A", produced by A & D Co., Ltd.), and strain (break elongation) (%) and stress (MPa) were measured until the sample broke. From the measurement results, a stress-strain curve was created with stress on the vertical axis and strain on the horizontal axis. Of the obtained stress-strain curve, an area of a figure surrounded by the stress-strain curve in a section from the origin to the breaking point, the vertical line drawn from the breaking point to the horizontal axis, and the horizontal axis were integrated. The calculated integration value (unit: MPa·%) was used as the toughness parameter of the measured sample.

### (Measurement condition)

· 500N load cell/rubber sample fixing jig
· Room temperature (25°C)
· Tensile speed 1 mm/min (constant speed)
· Load range 100N
· Distance between chucks 20 mm
· Chuck part shape file

From the obtained toughness parameters, the toughness of the thermally conductive sheet was evaluated based on the following criteria.

### (Toughness evaluation criteria)

"A+": Toughness parameter is 60 MPa·% or greater
"A": Toughness parameter is 45 MPa·% or greater and less than 60 MPa·%
"B": Toughness parameter is 30 MPa·% or greater and less than 45 MPa·%
"C": Toughness parameter is 15 MPa·% or greater and less than 30 MPa·%
"D": Toughness parameter is less than 15 MPa·%

### <Peel strength test>

The polyester film was peeled off from the semi-cured sheet with a polyester film prepared by the method, the obtained semi-cured sheet was cut into strips of 20 mm × 60 mm, and was sandwiched between an electrolytic copper foil (20 mm × 100 mm, thickness: 35 µm) which is an adherend and an aluminum plate (30 mm × 60 mm, thickness: 1 mm). The obtained laminate was heat-pressed under air (treated at a hot plate temperature of 180°C and a pressure of 20 MPa for 5 minutes, then treated at a hot plate temperature of 180°C and a normal pressure for 90 minutes) to obtain an aluminum base substrate with a copper foil integrated with the thermally conductive sheet and the adherend.

Using a digital force gauge (ZTS-200N, produced by Imada Co., Ltd.) and a 90-degree peeling test jig (P90-200N-BB, produced by Imada Co., Ltd.), the copper foil peel strength of the obtained sample was measured according to a method for measuring the peel strength under normal conditions described in JIS C 6481. The peeling of the copper foil in the peel strength test was performed at an angle of 90° and a peeling rate of 50 mm/min with respect to the aluminum base substrate with a copper foil.

From the copper foil peel strength measured by the method, the peel strength of the thermally conductive sheet was evaluated based on the following criteria. The higher the measured value, the better the peel strength of the thermally conductive sheet.

### (Peel strength evaluation criteria)

"A+": Peel strength is 5 N/cm or more
"A": Peel strength is 4 N/cm or more and less than 5 N/cm
"B": Peel strength is 3 N/cm or more and less than 4 N/cm
"C": Peel strength is 2 N/cm or more and less than 3 N/cm
"D": Peel strength is less than 2 N/cm

### <Evaluation of thermally conductive properties>

The semi-cured sheet prepared by the method was heat-treated under air (treated at a hot plate temperature of 180°C and a pressure of 20 MPa for 5 minutes, then treated at a hot plate temperature of 180°C, 90 minutes under normal pressure) to cure the sheet, and thereby a resin sheet sandwiched between the two polyester films was prepared. The polyester films on both surfaces of the resin sheet were peeled off to obtain a thermally conductive sheet having an average film thickness of 200 µm.

The thermal conductivity of the obtained thermally conductive sheet was measured by the following method. From the measured thermal conductivity, the thermally conductive properties of the thermally conductive sheets of each Example and each Comparative Example were evaluated according to the following evaluation criteria.

### (Measurement of thermal conductivity (W/m·k))

(1) Using "LFA467" produced by NETZSCH Japan K. K., the thermal diffusivity in a film thickness direction of the thermally conductive sheet was measured by a laser flash method.
(2) Using the balance "XS204" produced by Mettler Toledo, the specific gravity of the thermally conductive sheet was measured by the Archimedes method (using the "solid specific gravity measuring kit").
(3) Using "DSC320/6200" produced by Seiko Instruments Inc., the specific heat of the thermally conductive sheet at 25°C was determined under a temperature rising condition of 10°C/min.
(4) The obtained thermal diffusivity was multiplied by the specific gravity and the specific heat to calculate the thermal conductivity of the thermally conductive sheet.

### (Thermally conductive properties evaluation criteria)

"A+": Thermal conductivity is 15 W/m·K or greater
"A": Thermal conductivity is 10 W/m·K or greater and less than 15 W/m·K
"B": Thermal conductivity is 8 W/m·K or greater and less than 10 W/m·K
"C": Thermal conductivity is 5 W/m·K or greater and less than 8 W/m·K
"D": Thermal conductivity is less than 5 W/m·K

Tables 1 and 2 show the evaluation results of the toughness, peel strength and thermal conductivity of the thermally conductive sheets of each Example and each Comparative Example.

In Tables 1 and 2, the "amount (%)" of each component of the composition means the content (mass%) of each component with respect to the total mass of the solid content of the composition.

The "ratio" column of the "composition" represents the ratio (mass ratio) of the content of the specific polymer (thermoplastic resin or rubber) to the content of the inorganic particles.

In the "adhesive layer" column of the "thermally conductive sheet", the notation "none" indicates that each evaluation was performed on the thermally conductive sheet having no adhesive layer, and the notations of "1", "2", and "3" indicate that each evaluation was performed on the thermally conductive sheets having the adhesive layers 1 to 3 on both surfaces.

**[Table 1]**

| Table 1 | Composition | | | | | | | | | | |
|---|---|---|---|---|---|---|---|---|---|---|---|
| | Disk-like compound | | | | Curable compound | | Specific polymer | | Inorganic particles | | Ratio |
| | Kind | Amount (g) | Kind | Amount (g) | Kind | Amount (g) | Kind | Amount (g) | Configuration | Amount (g) | |
| Example 1 | A-2 | 10.2 | | | D-3 | 8.9 | E-1 | 4.6 | IP-1 | 76 | 0.061 |
| Example 2 | A-2 | 10.2 | | | D-3 | 8.9 | E-2 | 4.6 | IP-1 | 76 | 0.061 |
| Example 3 | A-2 | 10.2 | | | D-3 | 8.9 | E-3 | 4.6 | IP-1 | 76 | 0.061 |
| Example 4 | A-2 | 10.2 | | | D-3 | 8.9 | E-5 | 4.6 | IP-1 | 76 | 0.061 |
| Example 5 | A-2 | 10.2 | | | D-3 | 8.9 | E-6 | 4.6 | IP-1 | 76 | 0.061 |
| Example 6 | A-2 | 10.2 | | | D-3 | 8.9 | E-7 | 4.6 | IP-1 | 76 | 0.061 |
| Example 7 | A-2 | 10.2 | | | D-3 | 8.9 | E-8 | 4.6 | IP-1 | 76 | 0.061 |
| Example 8 | A-2 | 10.2 | | | D-3 | 8.9 | E-9 | 4.6 | IP-1 | 76 | 0.061 |
| Example 9 | A-2 | 11.4 | | | D-3 | 10.0 | E-2 | 2.3 | IP-1 | 76 | 0.030 |
| Example 10 | A-2 | 9.0 | | | D-3 | 7.8 | E-2 | 6.9 | IP-1 | 76 | 0.091 |
| Example 11 | A-2 | 7.7 | | | D-3 | 6.7 | E-2 | 9.2 | IP-1 | 76 | 0.121 |
| Example 12 | A-2 | 6.5 | | | D-3 | 5.7 | E-2 | 11.5 | IP-1 | 76 | 0.151 |
| Example 13 | A-2 | 14.3 | | | D-3 | 12.5 | E-2 | 6.9 | IP-1 | 66 | 0.105 |
| Example 14 | A-2 | 17.5 | | | D-3 | 15.3 | E-2 | 6.9 | IP-1 | 60 | 0.115 |
| Example 15 | A-2 | 20.7 | | | D-3 | 18.1 | E-2 | 6.9 | IP-1 | 54 | 0.128 |
| Example 16 | A-2 | 10.2 | | | D-3 | 8.9 | E-2 | 4.6 | IP-1 | 76 | 0.061 |
| Example 17 | A-2 | 10.2 | | | D-3 | 8.9 | E-2 | 4.6 | IP-1 | 76 | 0.061 |
| Example 18 | A-2 | 10.2 | | | D-3 | 8.9 | E-2 | 4.6 | IP-1 | 76 | 0.061 |
| Example 19 | A-2 | 10.2 | | | D-3 | 8.9 | E-2 | 4.6 | IP-2 | 76 | 0.061 |
| Example 20 | A-2 | 10.2 | | | D-3 | 8.9 | E-2 | 4.6 | IP-3 | 76 | 0.061 |
| Example21 | A-2 | 10.2 | | | D-3 | 8.9 | E-2 | 4.6 | IP-3 | 76 | 0.061 |
| Example 22 | A-2 | 10.2 | | | D-3 | 8.9 | E-2 | 4.6 | IP-3 | 76 | 0.061 |
| Example 23 | A-2 | 10.2 | | | D-3 | 8.9 | E-2 | 4.6 | IP-4 | 76 | 0.061 |
| Example 24 | A-2 | 10.2 | | | D-3 | 8.9 | E-2 | 4.6 | IP-5 | 76 | 0.061 |
| Example 25 | A-2 | 10.2 | | | D-3 | 8.9 | E-2 | 4.6 | IP-6 | 76 | 0.061 |
| Example 26 | A-2 | 10.2 | | | D-3 | 8.9 | E-2 | 4.6 | IP-7 | 76 | 0.061 |
| Example27 | A-2 | 10.2 | | | D-3 | 8.9 | E-2 | 4.6 | IP-7 | 76 | 0.061 |
| Example 28 | A-2 | 10.2 | | | D-3 | 8.9 | E-2 | 4.6 | IP-7 | 76 | 0.061 |
| Example 29 | A-2 | 10.2 | | | D-3 | 8.9 | E-2 | 4.6 | IP-8 | 76 | 0.061 |
| Example 30 | A-2 | 10.2 | | | D-3 | 8.9 | E-2 | 4.6 | IP-9 | 76 | 0.061 |

**[Table 2]**

| Table 1 (continued) | Composition | | | Thermally conductive sheet | | | |
|---|---|---|---|---|---|---|---|
| | Curing accelerator | | Dispersant | Adhesive layer | Toughness | Peel strength | Thermally conductive properties |
| | Kind | Amount (g) | Amount (g) | | | | |
| Example 1 | PPh3 | 0.16 | 0.17 | None | A+ | A+ | A+ |
| Example 2 | PPh3 | 0.16 | 0.17 | None | A+ | A+ | A+ |
| Example 3 | PPh3 | 0.16 | 0.17 | None | A+ | A+ | A+ |
| Example 4 | PPh3 | 0.16 | 0.17 | None | A+ | A+ | A+ |
| Example 5 | PPh3 | 0.16 | 0.17 | None | A+ | A+ | A+ |
| Example 6 | PPh3 | 0.16 | 0.17 | None | A+ | A+ | A+ |
| Example 7 | PPh3 | 0.16 | 0.17 | None | A+ | A+ | A |
| Example 8 | PPh3 | 0.16 | 0.17 | None | A+ | A+ | B |
| Example 9 | PPh3 | 0.16 | 0.17 | None | A | A | A+ |
| Example 10 | PPh3 | 0.16 | 0.17 | None | A+ | A+ | A |
| Example 11 | PPh3 | 0.16 | 0.17 | None | A+ | A+ | B |
| Example 12 | PPh3 | 0.16 | 0.17 | None | A+ | A+ | B |
| Example 13 | PPh3 | 0.16 | 0.17 | None | A+ | A+ | A |
| Example 14 | PPh3 | 0.16 | 0.17 | None | A+ | A+ | A |
| Example 15 | PPh3 | 0.16 | 0.17 | None | A+ | A+ | B |
| Example 16 | PPh3 | 0.16 | 0.17 | 1 | A+ | A+ | A+ |
| Example 17 | PPh3 | 0.16 | 0.17 | 2 | A+ | A+ | A+ |
| Example 18 | PPh3 | 0.16 | 0.17 | 3 | A+ | A+ | A+ |
| Example 19 | PPh3 | 0.16 | 0.17 | None | A+ | A+ | A+ |
| Example 20 | PPh3 | 0.16 | 0.17 | None | A+ | A+ | A+ |
| Example 21 | PPh3 | 0.16 | 0.17 | 2 | A+ | A+ | A+ |
| Example 22 | PPh3 | 0.16 | 0.17 | 3 | A+ | A+ | A+ |
| Example 23 | PPh3 | 0.16 | 0.17 | None | A+ | A+ | A+ |
| Example24 | PPh3 | 0.16 | 0.17 | None | A+ | A+ | A |
| Example 25 | PPh3 | 0.16 | 0.17 | None | A+ | A+ | A+ |
| Example 26 | PPh3 | 0.16 | 0.17 | None | A+ | A+ | A+ |
| Example 27 | PPh3 | 0.16 | 0.17 | 2 | A+ | A+ | A+ |
| Example 28 | PPh3 | 0.16 | 0.17 | 3 | A+ | A+ | A+ |
| Example 29 | PPh3 | 0.16 | 0.17 | None | A+ | A+ | A+ |
| Example 30 | PPh3 | 0.16 | 0.17 | None | A+ | A+ | A+ |

**[Table 3]**

| Table 2 | Composition | | | | | | | | | | |
|---|---|---|---|---|---|---|---|---|---|---|---|
| | Disk-like compound | | | | Curable compound | | Specific polymer | | Inorganic particles | | Ratio |
| | Kind | Amount (g) | Kind | Amount (g) | Kind | Amount (g) | Kind | Amount (g) | Configuration | Amount (g) | |
| Example 31 | A-2 | 7.9 | | | D-1 | 11.2 | E-2 | 4.6 | IP-1 | 76 | 0.061 |
| Example 32 | A-2 | 8.5 | | | D-2 | 10.5 | E-2 | 4.6 | IP-1 | 76 | 0.061 |
| Example 33 | A-2 | 8.4 | | | D-4 | 10.6 | E-2 | 4.6 | IP-1 | 76 | 0.061 |
| Example 34 | A-2 | 5.1 | B-1 | 14.0 | | | E-2 | 4.6 | IP-1 | 76 | 0.061 |
| Example 35 | A-2 | 7.9 | B-2 | 11.2 | | | E-2 | 4.6 | IP-1 | 76 | 0.061 |
| Example 36 | A-2 | 7.9 | B-3 | 11.2 | | | E-2 | 4.6 | IP-1 | 76 | 0.061 |
| Example 37 | | | B-1 | 16.6 | C-2 | 2.5 | E-2 | 4.6 | IP-1 | 76 | 0.061 |
| Example 38 | | | B-2 | 14.8 | C-2 | 4.3 | E-2 | 4.6 | IP-1 | 76 | 0.061 |
| Example 39 | | | B-3 | 14.8 | C-2 | 4.3 | E-2 | 4.6 | IP-1 | 76 | 0.061 |
| Example 40 | A-1 | 13.2 | B-3 | 5.8 | | | E-2 | 4.6 | IP-1 | 76 | 0.061 |
| Example 41 | A-3 | 7.9 | B-3 | 11.2 | | | E-2 | 4.6 | IP-1 | 76 | 0.061 |
| Example 42 | A-4 | 9.1 | B-3 | 10.0 | | | E-2 | 4.6 | IP-1 | 76 | 0.061 |
| Example 43 | A-5 | 8.2 | B-3 | 10.9 | | | E-2 | 4.6 | IP-1 | 76 | 0.061 |
| Example 44 | | | B-3 | 10.8 | C-1 | 8.2 | E-2 | 4.6 | IP-1 | 76 | 0.061 |
| Example 45 | | | B-3 | 12.2 | C-3 | 6.9 | E-2 | 4.6 | IP-1 | 76 | 0.061 |
| Example 46 | | | B-3 | 12.4 | C-4 | 6.7 | E-2 | 4.6 | IP-1 | 76 | 0.061 |
| Example 47 | | | B-3 | 13.9 | C-5 | 5.2 | E-2 | 4.6 | IP-1 | 76 | 0.061 |
| Example 48 | | | B-3 | 12.6 | C-6 | 6.4 | E-2 | 4.6 | IP-1 | 76 | 0.061 |
| Example 49 | A-1 | 15.0 | | | D-3 | 4.1 | E-2 | 4.6 | IP-1 | 76 | 0.061 |
| Example 50 | A-3 | 10.2 | | | D-3 | 8.9 | E-2 | 4.6 | IP-1 | 76 | 0.061 |
| Example 51 | A-4 | 11.4 | | | D-3 | 7.7 | E-2 | 4.6 | IP-1 | 76 | 0.061 |
| Example 52 | A-5 | 10.5 | | | D-3 | 8.6 | E-2 | 4.6 | IP-1 | 76 | 0.061 |
| Comparative Example 1 | | | | | C-6 | 6.4 | E-2 | 4.6 | IP-1 | 76 | 0.061 |
| | | | | | D-1 | 12.6 | | | | | |
| Comparative Example 2 | | | | | C-6 | 8.0 | | | IP-1 | 76 | - |
| | | | | | D-1 | 15.7 | | | | | |
| Comparative Example 3 | | | B-3 | 15.1 | C-3 | 8.5 | | | IP-1 | 76 | - |
| Comparative Example 4 | | | B-3 | 15.7 | C-6 | 8.0 | | | IP-1 | 76 | - |

**[Table 4]**

| Table 2 (continued) | Composition | | | Thermally conductive sheet | | | |
|---|---|---|---|---|---|---|---|
| | Curing accelerator | | Dispersant | Adhesive layer | Toughness | Peel strength | Thermally conductive properties |
| | Kind | Amount (g) | Amount (g) | | | | |
| Example 31 | PPh3 | 0.16 | 0.17 | None | A+ | A+ | A+ |
| Example 32 | PPh3 | 0.16 | 0.17 | None | A+ | A+ | A+ |
| Example 33 | PPh3 | 0.16 | 0.17 | None | A | A | A+ |
| Example 34 | PPh3 | 0.16 | 0.17 | None | A+ | A+ | A |
| Example 35 | PPh3 | 0.16 | 0.17 | None | A+ | A+ | A+ |
| Example 36 | PPh3 | 0.16 | 0.17 | None | A+ | A+ | A+ |
| Example 37 | PPh3 | 0.16 | 0.17 | None | A+ | A+ | A |
| Example 38 | PPh3 | 0.16 | 0.17 | None | A+ | A+ | A+ |
| Example 39 | PPh3 | 0.16 | 0.17 | None | A+ | A+ | A+ |
| Example 40 | PPh3 | 0.16 | 0.17 | None | A+ | A+ | A |
| Example 41 | PPh3 | 0.16 | 0.17 | None | A+ | A+ | A+ |
| Example 42 | PPh3 | 0.16 | 0.17 | None | A | A | A+ |
| Example 43 | PPh3 | 0.16 | 0.17 | None | A | A | A+ |
| Example 44 | PPh3 | 0.16 | 0.17 | None | A+ | A+ | A+ |
| Example 45 | PPh3 | 0.16 | 0.17 | None | A+ | A+ | A+ |
| Example 46 | PPh3 | 0.16 | 0.17 | None | A+ | A+ | A+ |
| Example 47 | PPh3 | 0.16 | 0.17 | None | A | A | A+ |
| Example 48 | PPh3 | 0.16 | 0.17 | None | A | A | A+ |
| Example 49 | PPh3 | 0.16 | 0.17 | None | A+ | A+ | A |
| Example 50 | PPh3 | 0.16 | 0.17 | None | A+ | A+ | A+ |
| Example 51 | PPh3 | 0.16 | 0.17 | None | A | A | A+ |
| Example52 | PPh3 | 0.16 | 0.17 | None | A | A | A+ |
| Comparative Example 1 | PPh3 | 0.16 | 0.17 | None | C | C | A+ |
| Comparative Example 2 | PPh3 | 0.16 | 0.17 | None | D | D | A+ |
| Comparative Example 3 | PPh3 | 0.16 | 0.17 | None | B | B | A+ |
| Comparative Example 4 | PPh3 | 0.16 | 0.17 | None | C | C | A+ |

From the results in Tables 1 and 2, it was confirmed that the thermally conductive sheet according to the embodiment of the present invention has excellent peel strength.

In addition, it was confirmed that in a case where the specific polymer is a thermoplastic resin having an aromatic ring in the main chain, the thermally conductive properties of the thermally conductive sheet is more excellent (comparison of Examples 1 to 8).

It was confirmed that in a case where the toughness parameter of the thermally conductive sheet is 45 MPa·%or greater, the peel strength of the thermally conductive sheet is more excellent (comparison between Example 2 and Example 9).

It was confirmed that in a case where the ratio of the content of the specific polymer to the content of the inorganic particles (content of the specific polymer/content of the inorganic particles) in the composition is 0.04 or more, by mass ratio, the peel strength of the thermally conductive sheet is more excellent (comparison between Example 2 and Example 9).

It was confirmed that in a case where the ratio of the content of the specific polymer to the content of the inorganic particles (content of the specific polymer/content of the inorganic particles) in the composition is 0.12 or less, by mass ratio, the thermally conductive properties of the thermally conductive sheet is more excellent (comparison between Example 14 and Example 11), and in a case where the same ratio is 0.08 or less, by mass ratio, the thermally conductive properties of the thermally conductive sheet is even more excellent (comparison between Example 2 and Example 10).

It was confirmed that in a case where the content of the inorganic nitride in the composition is 60% by mass or more with respect to the total mass of the inorganic particles, the thermally conductive properties of the thermally conductive sheet is more excellent (comparison between Examples 23 and Example 24).

It was confirmed that in a case where the number of functional groups having a main agent which is not a disk-like compound is 4 or less, the peel strength of the thermally conductive sheet is more excellent (comparison between Examples 2, 31, and 32 and Example 33).

It was confirmed that in a case where the number of functional groups of the curing agent which is not a disk-like compound is 4 or less, the peel strength of the thermally conductive sheet is more excellent (comparison between Examples 39 and 44 to 46 and Examples 47 and 48).

It was confirmed that in a case where all of the disk-like compounds are compounds represented by Formula (D16), the peel strength of the thermally conductive sheet is more excellent (comparison between Examples 2, 49, and 50 and Examples 51 and 52).

It was confirmed that in a case where all of the disk-like compounds are represented by any of Formulae (D1) to (D16) and in a case where the number of atoms between both ends of the divalent linking group is 11 or less, the thermally conductive properties of the thermally conductive sheet is more excellent (comparison between Examples 34 to 36, and comparison between Example 40 and Examples 36 and 41 to 43).

## Claims

1. A composition containing:
- a disk-like compound in a content of 1% to 50% by mass, with respect to a total mass of the solid content of the composition,
- a high-molecular-weight compound in a content of 0.1% to 30% by mass, with respect to a total mass of the solid content of the composition, and which is at least one selected from the group consisting of a thermoplastic resin and rubber, and
- inorganic particles in a content of 30% by mass or greater, with respect to a total mass of the solid content of the composition, wherein the inorganic particles are selected from particles of inorganic oxides, inorganic nitrides, and inorganic oxynitrides,
wherein the disk-like compound is represented by one of Formulae (D1) to (D16): 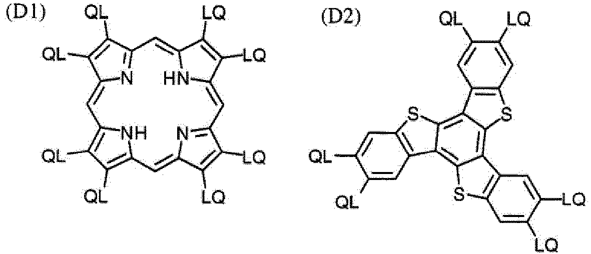 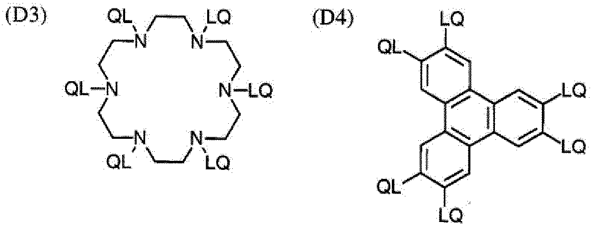 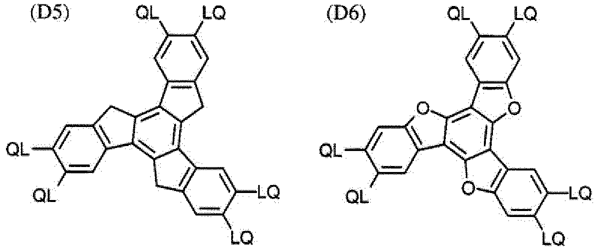 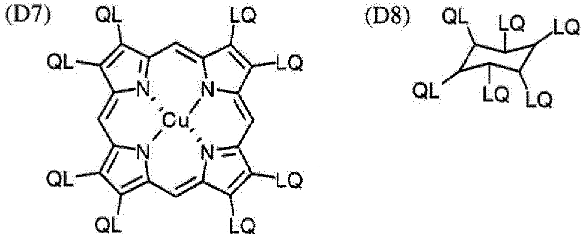 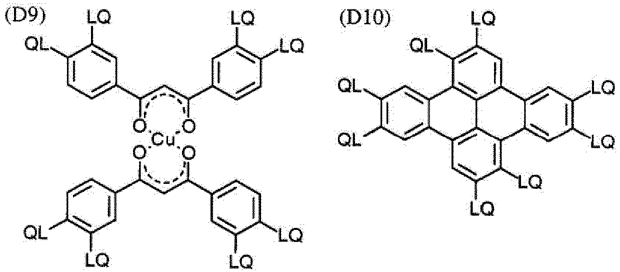 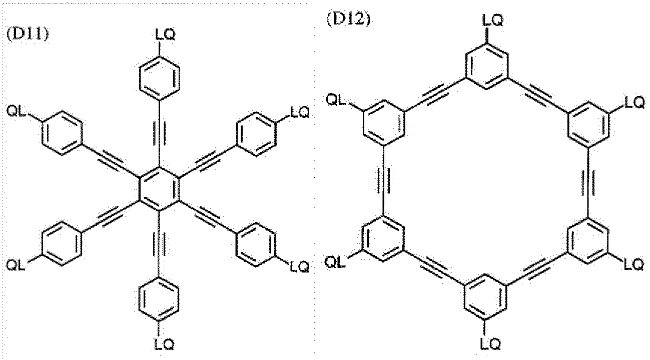 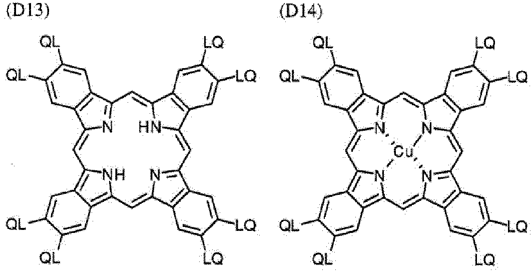 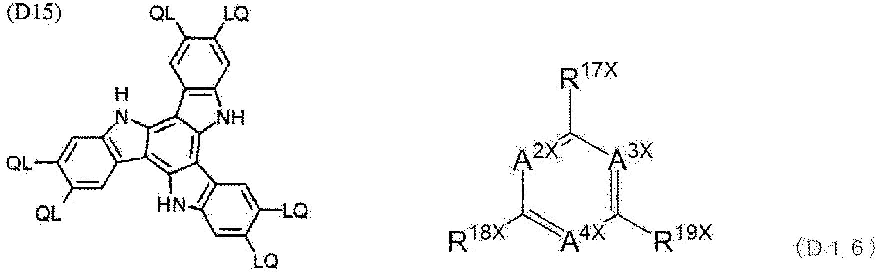 wherein:
A^{2X}, A^{3X}, and A^{4X} each independently represent -CH= or -N=;
R^{17X}, R^{18X}, and R^{19X} each independently represent *-(X^{211X}-Z^{21X})_{n21X}-L^{21X}-Q,
where * represents the bonding position with the central ring;
X^{211X} represents a single bond, -O-, -C(=O)-, -NH-, -OC (=O)-, -OC(=O)O-, -OC(=O)NH-, -OC(=O)S-, -C(=O)O-, -C(=O)NH-, -C (=O)S-, -NHC(=O)NH-, -NHC(=O)S -, -S-, -SC(=O)-, -SC(=O)O-, -SC(=O)NH-, or -SC(=O)S-;
Z^{21X} represents a 5-membered or 6-membered aromatic ring group or a 5-membered or 6-membered non-aromatic ring group;
L^{21X} represents a single bond or a divalent linking group;
n21X represents an integer of 0 to 3;
each L is the same or different and represents a divalent linking group; and
each Q is the same or different and represents a hydrogen atom or a substituent.

2. The composition according to claim 1,
wherein the high-molecular-weight compound contains a thermoplastic resin having an aromatic ring in a main chain.

3. The composition according to claim 1 or 2,
wherein the high-molecular-weight compound includes at least one selected from the group consisting of polysulfone, polyethersulfone, polyetheretherketone, polyetherimide, modified polyphenylene ether, polycarbonate, amorphous polyarylate, liquid crystal polymer, polyimide, and polyphenylene sulfide.

4. The composition according to any one of claims 1 to 3,
wherein a ratio of a content of the high-molecular-weight compound to a content of the inorganic particles is 0.01 to 0.2 by mass ratio.

5. The composition according to any one of claims 1 to 4,
wherein a ratio of a content of the high-molecular-weight compound to a content of the inorganic particles is 0.02 to 0.12 by mass ratio.

6. The composition according to any one of claims 1 to 5,
wherein a ratio of a content of the high-molecular-weight compound to a content of the inorganic particles is 0.04 to 0.08 by mass ratio.

7. The composition according to any one of claims 1 to 6,
wherein a content of the high-molecular-weight compound is 1% to 15% by mass with respect to a total mass of a solid content contained in the composition.

8. The composition according to any one of claims 1 to 7,
wherein a content of the high-molecular-weight compound is 3% to 10% by mass with respect to a total mass of a solid content contained in the composition.

9. The composition according to any one of claims 1 to 8,
wherein the inorganic particles are particles of an inorganic oxide or an inorganic nitride.

10. The composition according to any one of claims 1 to 9,
wherein the inorganic particles are boron nitride particles.

11. The composition according to any one of claims 1 to 10, further comprising a curing accelerator.

12. A thermally conductive sheet formed by curing the composition according to any one of claims 1 to 11.

13. The thermally conductive sheet according to claim 12,
wherein a toughness parameter of the thermally conductive sheet measured by the following Test method 1 is 30 MPa·% or greater,
Test method 1: the thermally conductive sheet is subjected to a tensile test at a tensile speed of 1 mm/min using a tensile tester in a temperature environment of 25°C, and stress and strain of the thermally conductive sheet are measured, from the obtained measurement results, a stress-strain curve is prepared with stress on a vertical axis and strain on a horizontal axis, an area of a figure surrounded by the stress-strain curve in a section from an origin to a breaking point of the obtained stress-strain curve, a vertical line drawn from the breaking point to the horizontal axis, and the horizontal axis are integrated, and a calculated integration value (unit: MPa·%) is used as the toughness parameter of the thermally conductive sheet.

14. The thermally conductive sheet according to claim 12 or 13,
wherein an adhesive layer or a pressure sensitive adhesive layer is provided on one surface or both surfaces of the thermally conductive sheet.

15. A device with a thermally conductive sheet comprising:
a device; and
the thermally conductive sheet according to any one of claims 12 to 14 disposed on the device.

## Patentansprüche

1. Zusammensetzung, enthaltend:
- eine scheibenartige Verbindung mit einem Gehalt von 1 Massen-% bis 50 Massen-%, in Bezug auf eine Gesamtmasse des Feststoffgehalts der Zusammensetzung,
- eine Verbindung mit hohem Molekulargewicht mit einem Gehalt von 0,1 Massen-% bis 30 Massen-%, in Bezug auf eine Gesamtmasse des Feststoffgehalts der Zusammensetzung, und die mindestens eine ist, die aus der Gruppe, die aus einem thermoplastischen Harz und Kautschuk besteht, ausgewählt wird, und
- anorganische Partikel mit einem Gehalt von 30 Massen-% oder mehr, in Bezug auf eine Gesamtmasse des Feststoffgehalts der Zusammensetzung, wobei die anorganischen Partikel aus Partikeln von anorganischen Oxiden, anorganischen Nitriden und anorganischen Oxynitriden ausgewählt werden,
wobei die scheibenartige Verbindung durch eine von Formeln (D1) bis (D16) dargestellt wird: 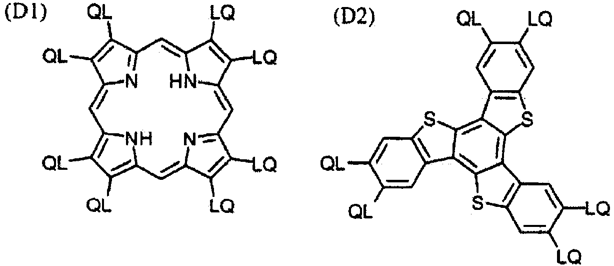 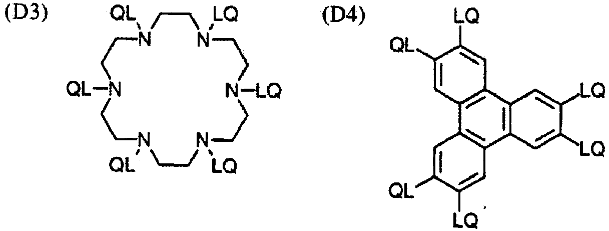 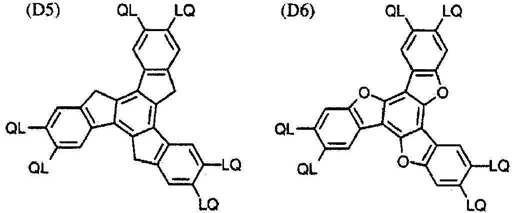 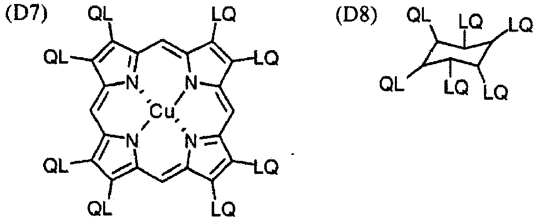 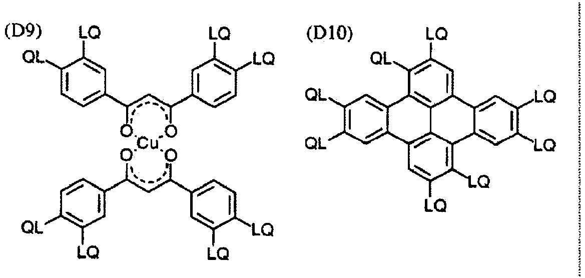 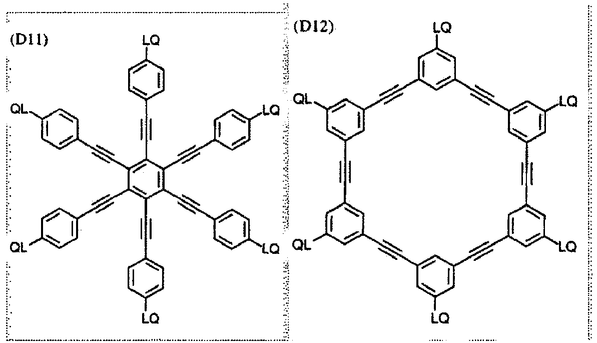 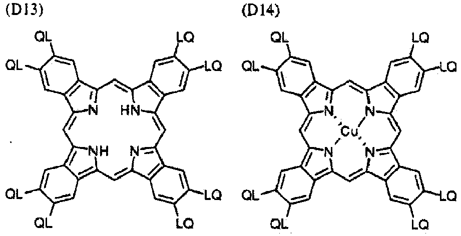 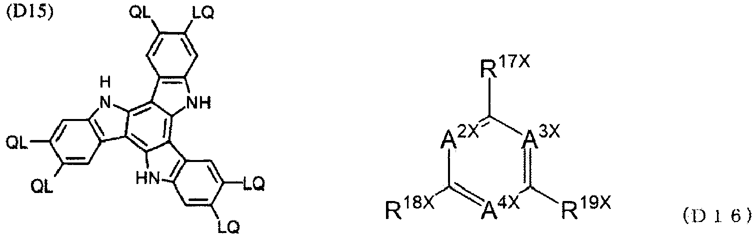 wobei:
A^{2X}, A^{3X} und A^{4X} jeweils unabhängig voneinander -CH= oder -N= darstellen;
R^{17X}, R^{18X} und R^{19X} jeweils unabhängig voneinander *-(X^{211X}-Z^{21X})_{n21X}-L^{21X}-Q darstellen,
wobei * die Bindungsposition mit dem zentralen Ring darstellt;
X^{211X} eine Einfachbindung, -O-, -C(=O)-, -NH-, -OC(=O)-, -OC(=O)O-, -OC(=O)NH-, -OC(=O)S-, -C(=O)O-, -C(=O)NH-, -C(=O)S-, -NHC(=O)NH-, -NHC(=O)S-, -S-, - SC(=O)-, -SC(=O)O-, -SC(=O)NH- oder -SC(=O)S- darstellt;
Z^{21X} eine 5-gliedrige oder 6-gliedrige aromatische Ringgruppe oder eine 5-gliedrige oder 6-gliedrige nicht aromatische Ringgruppe darstellt;
L^{21X} eine Einfachbindung oder eine divalente Verknüpfungsgruppe darstellt; n21X eine ganze Zahl von 0 bis 3 darstellt;
jedes L gleich oder unterschiedlich ist und eine divalente Verknüpfungsgruppe darstellt; und
jedes Q gleich oder unterschiedlich ist und ein Wasserstoffatom oder einen Substituenten darstellt.

2. Zusammensetzung nach Anspruch 1,
wobei die Verbindung mit hohem Molekulargewicht ein thermoplastisches Harz mit einem aromatischen Ring in einer Hauptkette enthält.

3. Zusammensetzung nach Anspruch 1 oder 2,
wobei die Verbindung mit hohem Molekulargewicht mindestens eines, das aus der Gruppe, die aus Polysulfon, Polyethersulfon, Polyetheretherketon, Polyetherimid, modifiziertem Polyphenylenether, Polycarbonat, amorphem Polyarylat, Flüssigkristallpolymer, Polyimid und Polyphenylensulfid besteht, ausgewählt wird, enthält.

4. Zusammensetzung nach einem der Ansprüche 1 bis 3,
wobei ein Verhältnis eines Gehalts der Verbindung mit hohem Molekulargewicht zu einem Gehalt der anorganischen Partikel 0,01 bis 0,2 im Massenverhältnis beträgt.

5. Zusammensetzung nach einem der Ansprüche 1 bis 4,
wobei ein Verhältnis eines Gehalts der Verbindung mit hohem Molekulargewicht zu einem Gehalt der anorganischen Partikel 0,02 bis 0,12 im Massenverhältnis beträgt.

6. Zusammensetzung nach einem der Ansprüche 1 bis 5,
wobei ein Verhältnis eines Gehalts der Verbindung mit hohem Molekulargewicht zu einem Gehalt der anorganischen Partikel 0,04 bis 0,08 im Massenverhältnis beträgt.

7. Zusammensetzung nach einem der Ansprüche 1 bis 6,
wobei ein Gehalt der Verbindung mit hohem Molekulargewicht 1 Massen-% bis 15 Massen-% in Bezug auf eine Gesamtmasse eines Feststoffgehalts, der in der Zusammensetzung enthalten ist, beträgt.

8. Zusammensetzung nach einem der Ansprüche 1 bis 7,
wobei ein Gehalt der Verbindung mit hohem Molekulargewicht 3 Massen-% bis 10 Massen-% in Bezug auf eine Gesamtmasse eines Feststoffgehalts, der in der Zusammensetzung enthalten ist, beträgt.

9. Zusammensetzung nach einem der Ansprüche 1 bis 8,
wobei die anorganischen Partikel Partikel eines anorganischen Oxids oder eines anorganischen Nitrids sind.

10. Zusammensetzung nach einem der Ansprüche 1 bis 9,
wobei die anorganischen Partikel Bornitridpartikel sind.

11. Zusammensetzung nach einem der Ansprüche 1 bis 10, ferner umfassend einen Härtungsbeschleuniger.

12. Wärmeleitendes Blatt, das durch Härtung der Zusammensetzung nach einem der Ansprüche 1 bis 11 gebildet ist.

13. Wärmeleitendes Blatt nach Anspruch 12,
wobei ein Zähigkeitsparameter des wärmeleitenden Blatts, der durch das folgende Testverfahren 1 gemessen wird, 30 MPa·% oder größer ist,
Testverfahren 1: das wärmeleitende Blatt wird einem Zugtest mit einer Zuggeschwindigkeit von 1 mm/min unter Verwendung eines Zugprüfgeräts in einer Temperaturumgebung von 25 °C unterzogen, und Spannung und Dehnung des wärmeleitenden Blatts werden gemessen, aus den erhaltenen Messergebnissen wird eine Spannungs-Dehnungskurve mit Spannung auf einer vertikalen Achse und Dehnung auf einer horizontalen Achse erstellt, eine Fläche einer Figur, die von der Spannungs-Dehnungskurve in einem Abschnitt von einem Ursprung zu einem Bruchpunkt der erhaltenen Spannungs-Dehnungskurve, einer vertikalen Linie, die von dem Bruchpunkt zu der horizontalen Achse gezeichnet ist, und der horizontalen Achse umgeben ist, wird integriert, und ein berechneter Integrationswert (Einheit: MPa·%) wird als der Zähigkeitsparameter des wärmeleitenden Blatts verwendet.

14. Wärmeleitendes Blatt nach Anspruch 12 oder 13,
wobei eine Klebstoffschicht oder eine druckempfindliche Klebstoffschicht auf einer Oberfläche oder beiden Oberflächen des wärmeleitenden Blatts vorgesehen ist.

15. Vorrichtung mit einem wärmeleitenden Blatt, umfassend:
eine Vorrichtung; und
das wärmeleitende Blatt nach einem der Ansprüche 12 bis 14, das auf der Vorrichtung angeordnet ist.

## Revendications

1. Composition contenant :
- un composé en forme de disque à une teneur de 1 % à 50 % en masse, par rapport à une masse totale de la teneur en solides de la composition,
- un composé de poids moléculaire élevé à une teneur de 0,1 % à 30 % en masse, par rapport à une masse totale de la teneur en solides de la composition, et qui est au moins un composé choisi dans le groupe constitué d'une résine thermoplastique et d'un caoutchouc, et
- des particules inorganiques à une teneur de 30 % en masse ou plus, par rapport à une masse totale de la teneur en solides de la composition, dans lesquelles les particules inorganiques sont choisies parmi des particules d'oxydes inorganiques, de nitrures inorganiques et d'oxynitrures inorganiques,
dans laquelle le composé en forme de disque est représenté par l'une des Formules (D1) à (D16) : 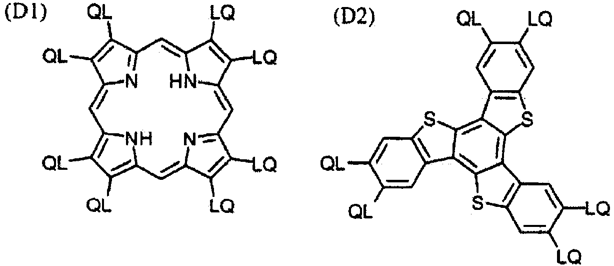 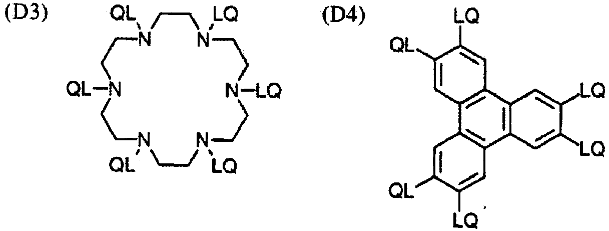 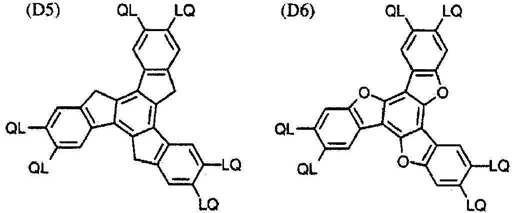 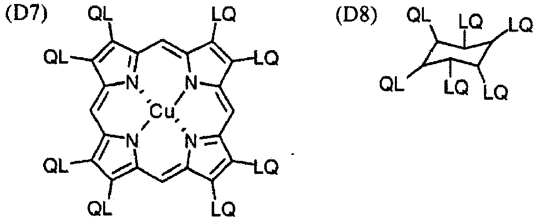 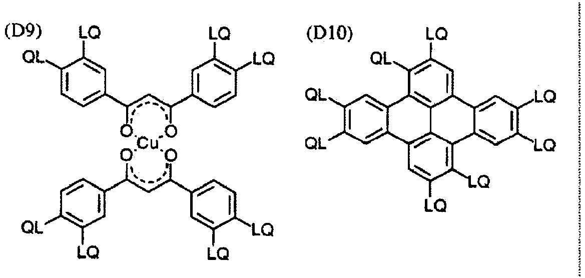 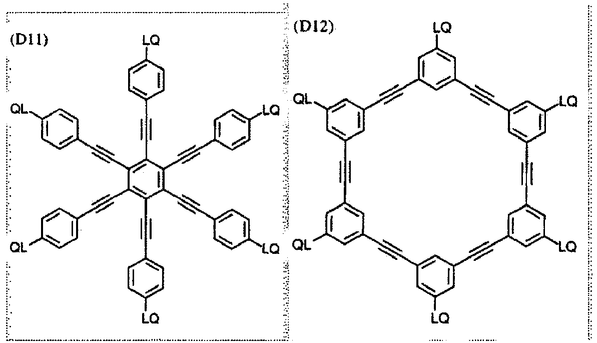 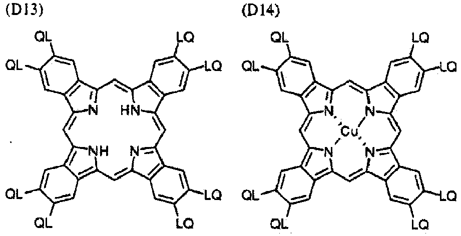 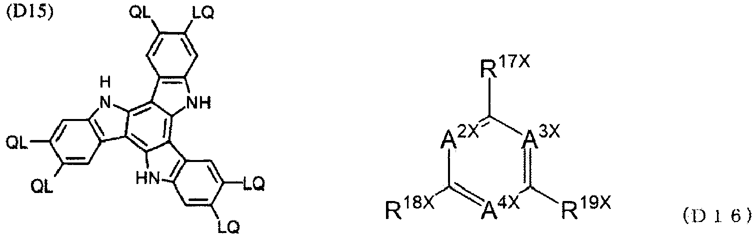 dans laquelle :
A^{2X}, A^{3X} et A^{4X} représentent chacun indépendamment -CH= ou -N= ;
R^{17X}, R^{18X} et R^{19X} représentent chacun indépendamment *-(X^{211X}-Z^{21X})_{n21X}-L^{21X}-Q, où * représente la position de liaison avec le cycle central ;
X^{211X} représente une liaison simple, -O-, -C(=O)-, -NH-, -OC(=O)-, -OC(=O)O-, - OC(=O)NH-, -OC(=O)S-, -C(=O)O-, -C(=O)NH-, -C(=O)S-, -NHC(=O)NH-, - NHC(=O)S-, -S-, -SC(=O)-, -SC(=O)O-, -SC(=O)NH- ou -SC(=O)S- ;
Z^{21X} représente un groupe de cycle aromatique à 5 ou 6 chaînons ou un groupe de cycle non aromatique à 5 ou 6 chaînons ;
L^{21X} représente une liaison simple ou un groupe de liaison divalent ;
n21X représente un entier de 0 à 3 ;
chaque L est identique ou différent et représente un groupe de liaison divalent ; et chaque Q est identique ou différent et représente un atome d'hydrogène ou un substituant.

2. Composition selon la revendication 1,
dans laquelle le composé de poids moléculaire élevé contient une résine thermoplastique comportant un cycle aromatique dans une chaîne principale.

3. Composition selon la revendication 1 ou la revendication 2,
dans laquelle le composé de poids moléculaire élevé inclut au moins un composé choisi dans le groupe constitué de polysulfone, polyéthersulfone, polyétheréthercétone, polyétherimide, éther de polyphénylène modifié, polycarbonate, polyarylate amorphe, polymère à cristaux liquides, polyimide et sulfure de polyphénylène.

4. Composition selon l'une quelconque des revendications 1 à 3,
dans laquelle un rapport entre une teneur du composé de poids moléculaire élevé et une teneur des particules inorganiques est de 0,01 à 0,2 en rapport de masse.

5. Composition selon l'une quelconque des revendications 1 à 4,
dans laquelle un rapport entre une teneur du composé de poids moléculaire élevé et une teneur des particules inorganiques est de 0,02 à 0,12 en rapport de masse.

6. Composition selon l'une quelconque des revendications 1 à 5,
dans laquelle un rapport entre une teneur du composé de poids moléculaire élevé et une teneur des particules inorganiques est de 0,04 à 0,08 en rapport de masse.

7. Composition selon l'une quelconque des revendications 1 à 6,
dans laquelle une teneur du composé de poids moléculaire élevé est de 1 % à 15 % en masse par rapport à une masse totale d'une teneur en solides contenue dans la composition.

8. Composition selon l'une quelconque des revendications 1 à 7,
dans laquelle une teneur du composé de poids moléculaire élevé est de 3 % à 10 % en masse par rapport à une masse totale d'une teneur en solides contenue dans la composition.

9. Composition selon l'une quelconque des revendications 1 à 8,
dans laquelle les particules inorganiques sont des particules d'un oxyde inorganique ou d'un nitrure inorganique.

10. Composition selon l'une quelconque des revendications 1 à 9,
dans laquelle les particules inorganiques sont des particules de nitrure de bore.

11. Composition selon l'une quelconque des revendications 1 à 10, comprenant en outre un accélérateur de durcissement.

12. Feuille thermoconductrice formée par durcissement de la composition selon l'une quelconque des revendications 1 à 11.

13. Feuille thermoconductrice selon la revendication 12,
dans laquelle un paramètre de ténacité de la feuille thermoconductrice mesuré selon la méthode d'essai 1 suivante est de 30 MPa·% ou plus,
méthode d'essai 1 : la feuille thermoconductrice est soumise à un test de traction à une vitesse de traction de 1 mm/min à l'aide d'un appareil d'essai de traction dans un environnement de température de 25 °C, et la contrainte et la déformation de la feuille thermoconductrice sont mesurées, à partir des résultats de mesure obtenus, une courbe contrainte-déformation est préparée avec la contrainte sur un axe vertical et la déformation sur un axe horizontal, une aire d'une figure délimitée par la courbe contrainte-déformation dans une section allant d'une origine jusqu'à un point de rupture de la courbe contrainte-déformation obtenue, une ligne verticale tracée du point de rupture jusqu'à l'axe horizontal, et l'axe horizontal est intégrée, et une valeur d'intégration calculée (unité : MPa·%) est utilisée comme le paramètre de ténacité de la feuille thermoconductrice.

14. Feuille thermoconductrice selon la revendication 12 ou la revendication 13,
dans laquelle une couche adhésive ou une couche adhésive sensible à la pression est prévue sur une surface ou sur les deux surfaces de la feuille thermoconductrice.

15. Dispositif comportant une feuille thermoconductrice comprenant :
un dispositif ; et
la feuille thermoconductrice selon l'une quelconque des revendications 12 à 14 disposée sur le dispositif.
